# EUROPEAN PATENT SPECIFICATION

(11) **EP 2 386 124 B1**
(45) Date of publication and mention of the grant of the patent: **26.12.2018**
(21) Application number: 10813861.1
(22) Date of filing: 11.01.2010
(51) Int. Cl.: H01L 31/028, H01L 31/075, H01L 31/076, H01L 31/036

(54) **SOLAR CELL**
SOLARZELLE
CELLULE SOLAIRE

(30) Priority: 02.09.2009 KR 20090082333; 26.11.2009 KR 20090115050
(43) Date of publication of application: 16.11.2011
(73) Proprietor: LG Electronics Inc., Seoul 150-721 (KR)
(72) Inventor: LEE, Hongcheol, Seoul 137-724 (KR); MOON, Seyoun, Seoul 137-724 (KR); AHN, Sehwon, Seoul 137-724 (KR); YOU, Dongjoo, Seoul 137-724 (KR)
(74) Representative: Katérle, Axel
(86) International application number: PCT/KR2010/000156
(87) International publication number: WO 2011/027951

(56) References cited:
- WO-A1-2009/015213
- JP-A- 11 135 818
- JP-A- 2000 150 935
- KR-A- 20080 003 624
- US-A- 5 635 408
- US-A- 5 716 480
- US-A1- 2008 096 305
- PLATZ R ET AL: "H2-dilution vs. buffer layers for increased Voc", AMORPHOUS SILICON TECHNOLOGY - 1996. SAN FRANCISCO, CA, APRIL 8 - 12, 1996; [MATERIALS RESEARCH SOCIETY SYMPOSIUM PROCEEDINGS. VOL. 420], PITTSBURGH, PA : MRS, US, 8 April 1996 (1996-04-08), pages 51-56, XP002558496, ISBN: 978-1-55899-323-5
- RANIERO L ET AL: "Role of buffer layer on the performances of amorphous silicon solar cells with incorporated nanoparticles produced by plasma enhanced chemical vapor deposition at 27.12 MHz", THIN SOLID FILMS, ELSEVIER-SEQUOIA S.A. LAUSANNE, CH, vol. 487, no. 1-2, 1 September 2005 (2005-09-01), pages 170-173, XP027866076, ISSN: 0040-6090 [retrieved on 2005-09-01]

## Description

### Technical Field

Embodiments of the invention relate to a solar cell.

### Background Art

A solar cell is an element capable of converting light energy into electrical energy, and which includes a p-type semiconductor layer and an n-type semiconductor layer.

A general operation of the solar cell is as follows. If light coming from the outside is incident on the solar cell, electron-hole pairs are formed inside a semiconductor layer of the solar cell. The electrons move toward the n-type semiconductor layer and the holes move toward the p-type semiconductor layer by an electric field generated inside the semiconductor layer of the solar cell. Hence, electric power is produced.

The solar cell may be mainly classified into a silicon-based solar cell, a compound semiconductor-based solar cell, and an organic-based solar cell depending on a material used. The silicon-based solar cell may be classified into a crystalline silicon (c-Si) solar cell and an amorphous silicon (a-Si) solar cell depending on a phase of a semiconductor.

WO 2009/015213 A1 discloses a solar cells and methods and apparatuses for forming the same. More particularly, there are thin film multi-junction solar cells and methods and apparatuses for forming the same. There is also an improved thin film silicon solar cell, and methods and apparatus for forming the same, where one or more of the layers in the solar cell comprises at least one amorphous silicon layer that has improved electrical characteristics and mechanical properties, and is capable of being deposited at rates many times faster than conventional amorphous silicon deposition process. In one embodiment a solar cell is disclosed which comprises a photoelectric transformation unit including a p-in p-type semiconductor structure and a buffer layer between the p-type layer and the i-type layer, wherein a hydrogen content of the buffer layer is more than a hydrogen content of the i-type semiconductor layer and the i-type semiconductor layer is formed of microcrystalline silicon with uniform crystallinity.

US 2008/0096305 A1 discloses a method of forming a deposited film containing microcrystalline silicon by plasma-enhanced CVD for forming solar cells.

US 5,716,480 A discloses
a photovoltaic device having a pin type semiconductor junction in which a p-type semiconductor layer and an n-type semiconductor layer are laminated with an interposed i-type semiconductor layer, comprising at least one doped layer of a non-monocrystal semiconductor disposed under and/or over the i-type semiconductor layer, wherein the at least one doped layer has a surface exposed to a plasma containing a band gap increasing element.

### Disclosure of Invention

### Solution to Problem

According to the disclosure, there are provided an apparatus and a manufacturing method according to the independent claims. Developments are set forth in the dependent claims.

Preferably, there is a solar cell comprising a substrate, a first electrode on the substrate, a second electrode, and at least one photoelectric transformation unit positioned between the first electrode and the second electrode, the at least one photoelectric transformation unit including a p-type semiconductor layer, an intrinsic (i-type) semiconductor layer, an n-type semiconductor layer, and a buffer layer positioned between the p-type semiconductor layer and the i-type semiconductor layer, a hydrogen content of the buffer layer being more than a hydrogen content of the i-type semiconductor layer.

The i-type semiconductor layer preferably is formed of amorphous silicon. The i-type semiconductor layer preferably is formed of microcrystalline silicon.

A thickness of the buffer layer preferably is less than a thickness of the i-type semiconductor layer. A thickness of the buffer layer preferably is less than a thickness of the p-type semiconductor layer.

The hydrogen content of the buffer layer preferably is more than a hydrogen content of the p-type semiconductor layer.

The i-type semiconductor layer preferably is formed of microcrystalline silicon. A crystallinity of the i-type semiconductor layer in a junction position between the buffer layer and the i-type semiconductor layer preferably is equal to or greater than 50 % of a crystallinity of the i-type semiconductor layer in a junction position between the i-type semiconductor layer and the n-type semiconductor layer.

The crystallinity of the i-type semiconductor layer in the junction position between the buffer layer and the i-type semiconductor layer preferably is equal to or greater than 75 % of the crystallinity of the i-type semiconductor layer in the junction position between the i-type semiconductor layer and the n-type semiconductor layer.

Preferably, there is a solar cell comprising a substrate, a first electrode on the substrate, a second electrode, a first photoelectric transformation unit positioned between the first electrode and the second electrode, the first photoelectric transformation unit including a first p-type semiconductor layer, a first intrinsic (i-type) semiconductor layer formed of amorphous silicon, a first n-type semiconductor layer, and a first buffer layer positioned between the first p-type semiconductor layer and the first i-type semiconductor layer, a hydrogen content of the first buffer layer being more than a hydrogen content of the first i-type semiconductor layer, and a second photoelectric transformation unit positioned between the first photoelectric transformation unit and the second electrode, the second photoelectric transformation unit including a second p-type semiconductor layer, a second intrinsic (i-type) semiconductor layer formed of microcrystalline silicon, a second n-type semiconductor
layer, and a second buffer layer positioned between the second p-type semiconductor layer and the second i-type semiconductor layer, a hydrogen content of the second buffer layer being more than a hydrogen content of the second i-type semiconductor layer.

A thickness of the first buffer layer preferably is less than a thickness of the first i-type semiconductor layer, and a thickness of the second buffer layer preferably is less than a thickness of the second i-type semiconductor layer.

A crystallinity of the second i-type semiconductor layer in a junction position between the second buffer layer and the second i-type semiconductor layer preferably equal to or greater than 50 % of a crystallinity of the second i-type semiconductor layer in a junction position between the second i-type semiconductor layer and the second n-type semiconductor layer.

The crystallinity of the second i-type semiconductor layer in the junction position between the second buffer layer and the second i-type semiconductor layer preferably is equal to or greater than 75 % of the crystallinity of the second i-type semiconductor layer in the junction position between the second i-type semiconductor layer and the second n-type semiconductor layer.

A thickness of the second i-type semiconductor layer preferably is greater than a thickness of the first i-type semiconductor layer, and a thickness of the second buffer layer preferably is greater than a thickness of the first buffer layer.

A thickness of the second i-type semiconductor layer preferably is greater than a thickness of the first i-type semiconductor layer. The hydrogen content of the first buffer layer preferably is more than the hydrogen content of the second buffer layer.

The hydrogen content of the first buffer layer preferably is more than a hydrogen content of the first p-type semiconductor layer, and the hydrogen content of the second buffer layer preferably is less than a hydrogen content of the second p-type semiconductor layer.

Preferably, there is a solar cell comprising a substrate, a first electrode on the substrate, a second electrode, a first photoelectric transformation unit positioned between the first electrode and the second electrode, the first photoelectric transformation unit including a first p-type semiconductor layer, a first intrinsic (i-type) semiconductor layer formed of amorphous silicon, a first n-type semiconductor layer, and a first buffer layer positioned between the first p-type semiconductor layer and the first i-type semiconductor layer, and a second photoelectric transformation unit positioned between the first photoelectric transformation unit and the second electrode, the second photoelectric transformation unit including a second p-type semiconductor layer, a second intrinsic (i-type) semiconductor layer formed of microcrystalline silicon, a second n-type semiconductor layer, and a second buffer layer positioned between the second p-type semiconductor layer and the second i-type semiconductor layer. A difference between a hydrogen content of the second i-type semiconductor layer and a hydrogen content of the second buffer layer is greater than a difference between a hydrogen content of the first i-type semiconductor layer and a hydrogen content of the first buffer layer.

The hydrogen content of the first buffer layer preferably is more than the hydrogen content of the first i-type semiconductor layer, and the hydrogen content of the second buffer layer preferably is more than the hydrogen content of the second i-type semiconductor layer.

Preferably, there is a solar cell comprising a substrate, a first electrode on the substrate, a second electrode, and at least one photoelectric transformation unit positioned between the first electrode and the second electrode, the at least one photoelectric transformation unit including a p-type semiconductor layer, an intrinsic (i-type) semiconductor layer, and an n-type semiconductor layer, the i-type semiconductor layer including first and second portions each having a different hydrogen content.

A hydrogen content of the first portion preferably is more than a hydrogen content of the second portion. The first portion preferably is positioned between the second portion and the p-type semiconductor layer.

A thickness of the first portion preferably is less than a thickness of the second portion.

### Brief Description of Drawings

FIGS. 1 to 5 relate to solar cells according to embodiments of the invention;
FIGS. 6 to 10 relate to double junction solar cells according to embodiments of the invention;
FIGS. 11 and 12 illustrate other structures of solar cells according to embodiments of the invention;
FIGS. 13 to 16 illustrate other structures of solar cells according to embodiments of the invention; and
FIGS. 17 to 32 relate to examples of doping intrinsic semiconductor layers with impurities according to embodiments of the invention.

### Mode for the Invention

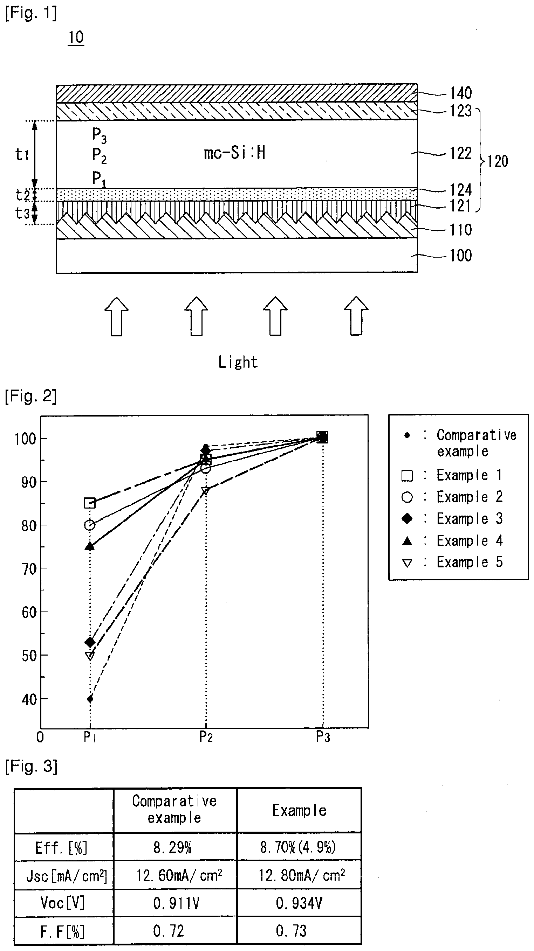

FIGS. 1 to 5 relate to solar cells according to embodiments of the invention. A structure of the solar cell shown in FIG. 1 may be referred to as a pin structure.

As shown in FIG. 1, a solar cell 10 according to an embodiment of the invention includes a substrate 100, a front electrode 110 on the substrate 100, a rear electrode 140, and a photoelectric transformation unit 120.

The photoelectric transformation unit 120 is positioned between the front electrode 110 and the rear electrode 140 to produce electric power using light coming from the outside. Further, the photoelectric transformation unit 120 may include an intrinsic (referred to as an i-type) semiconductor layer 122 formed of microcrystalline silicon.

The substrate 100 may provide a space for other functional layers. Further, the substrate 100 may be formed of a transparent material, such as glass and plastic, so that light coming from the outside is efficiently incident on the photoelectric transformation unit 120.

The front electrode 110 may be formed of a transparent material with electrical conductivity so as to increase a transmittance of incident light. For example, the front electrode 110 may be formed of a material, having high transmittance and high electrical conductivity, selected from the group consisting of indium tin oxide (ITO), tin-based oxide (for example, SnO₂), AgO, ZnO-Ga₂O₃ (or Al₂O₃), fluorine tin oxide (FTO), and a combination thereof, so that the front electrode 110 transmits most of incident light and a current flows in the front electrode 110. A specific resistance of the front electrode 110 may be approximately 10⁻² Ωcm to 10⁻¹¹ Qcm.

The front electrode 110 may be formed on the entire surface of the substrate 100 and may be electrically connected to the photoelectric transformation unit 120. Hence, the front electrode 110 may collect one (for example, holes) of carriers produced by the incident light to output the holes.

A plurality of uneven patterns having an uneven pyramid structure may be formed on an upper surface of the front electrode 110. In other words, the front electrode 110 may have a textured surface. As above, when the surface of the front electrode 110 is textured, a reflectance of light may be reduced, and an absorbance of light may increase. Hence, the efficiency of the solar cell 10 may be improved.

Although FIG. 1 shows the textured surface of the front electrode 110, the photoelectric transformation unit 120 may have a textured surface. In the embodiment of the invention, the textured surface of the front electrode 110 is described below for the convenience of explanation.

The rear electrode 140 may be formed of metal with a high electrical conductivity so as to increase a recovery efficiency of electric power produced by the photoelectric transformation unit 120. Further, the rear electrode 140 electrically connected to the photoelectric transformation unit 120 may collect one (for example, electrons) of the carriers produced by incident light to output the electrons.

The photoelectric transformation unit 120 may convert light from the outside into electrical energy. The photoelectric transformation unit 120 may be a silicon cell using microcrystalline silicon, for example, hydrogenated microcrystalline silicon (mc-Si:H). The photoelectric transformation unit 120 may include a p-type semiconductor layer 121, an intrinsic (i-type) semiconductor layer 122, an n-type semiconductor layer 123, and a buffer layer 124 that are formed on the front electrode 110 in the order named.

The p-type semiconductor layer 121 may be formed using a gas obtained by adding impurities of a group III element, such as boron (B), gallium (Ga), and indium (In), to a raw gas containing Si.

The i-type semiconductor layer 122 may reduce recombination of the carriers and may absorb light. The i-type semiconductor layer 122 may absorb incident light to produce carriers such as electrons and holes. The i-type semiconductor layer 122 may be formed of microcrystalline silicon, for example, hydrogenated microcrystalline silicon (mc-Si:H).

The n-type semiconductor layer 123 may be formed using a gas obtained by adding impurities of a group V element, such as phosphor (P), arsenic (As), and antimony (Sb), to a raw gas containing Si.

The photoelectric transformation unit 120 may be formed using a chemical vapor deposition (CVD) method, such as a plasma enhanced chemical vapor deposition (PECVD) method.

In the photoelectric transformation unit 120, the p-type semiconductor layer 121 and the n-type semiconductor layer 123 may form a p-n junction with the i-type semiconductor layer 122 interposed between the p-type semiconductor layer 121 and the n-type semiconductor layer 123. In other words, the i-type semiconductor layer 122 is positioned between the p-type semiconductor layer 121 (i.e., a p-type doped layer) and the n-type semiconductor layer 123 (i.e., an n-type doped layer), so as to form the pin structure.

In such a structure of the solar cell 10, when light is incident on the p-type semiconductor layer 121, a depletion region is formed inside the i-type semiconductor layer 122 because of the p-type semiconductor layer 121 and the n-type semiconductor layer 123 each having a relatively high doping concentration to thereby generate an electric field. Electrons and holes generated in the i-type semiconductor layer 122, being a light absorbing layer, are separated by a contact potential difference through a photovoltaic effect and move in different directions. For example, the holes move to the front electrode 110 through the p-type semiconductor layer 121, and the electrons move to the rear electrode 140 through the n-type semiconductor layer 123. Hence, electric power is produced.

The buffer layer 124 is positioned between the i-type semiconductor layer 122 and the p-type semiconductor layer 121. A hydrogen content of the buffer layer 124 may be more than a hydrogen content of the i-type semiconductor layer 122. More specifically, the hydrogen content of the i-type semiconductor layer 122 formed of microcrystalline silicon may be approximately 3 % to 5 %, and the hydrogen content of the buffer layer 124 may be approximately 12 % to 30 %. As above, when the buffer layer 124 is positioned between the i-type semiconductor layer 122 and the p-type semiconductor layer 121, crystallinity of the i-type semiconductor layer 122 may be uniform. Hence, the efficiency of the solar cell 10 may be improved.

FIG. 2 illustrates crystallinity depending on a depth of the i-type semiconductor layer in a comparative example not including the buffer layer and examples 1 to 5 according to embodiments of the invention. Supposing that a crystallinity of the i-type semiconductor layer at a position P3 is 100 in FIG. 2, FIG. 2 illustrates a crystallinity of the i-type semiconductor layer at each of positions P1 and P2 in the comparative example and the examples 1 to 5. In FIG. 2, the position P3 indicates a junction position between the i-type semiconductor layer and the n-type semiconductor layer, the position P2 indicates a middle position of the i-type semiconductor layer, and the position P1 indicates a junction position between the i-type semiconductor layer and the p-type semiconductor layer.

A structure of a solar cell according to the examples 1 to 5 is substantially the same as the structure of the solar cell 10 shown in FIG. 1, except the hydrogen content of the buffer layer 124. More specifically, there is a relatively small difference between the hydrogen content of the buffer layer and the hydrogen content of the i-type semiconductor layer in the examples 3 and 5. Further, there is a relatively large difference between the hydrogen content of the buffer layer and the hydrogen content of the i-type semiconductor layer in the examples 1, 2, and 4.

As shown in FIG. 2, in the comparative example not including the buffer layer, the crystallinity of the i-type semiconductor layer at the position P1 is approximately 40 % based on the crystallinity of the i-type semiconductor layer at the position P3. Further, in the comparative example, the crystallinity of the i-type semiconductor layer at the position P2 is approximately 98 % based on the crystallinity of the i-type semiconductor layer at the position P3.

In the comparative example, the i-type semiconductor layer has the properties similar to amorphous silicon at an initial formation stage of the i-type semiconductor layer and has the properties similar to microcrystalline silicon when the formation process of the i-type semiconductor layer is almost completed.

In other words, in the comparative example, there is a relatively large difference between the crystallinity of the i-type semiconductor layer at the initial formation stage and the crystallinity of the i-type semiconductor layer when the formation process of the i-type semiconductor layer is almost completed. This indicates that it is difficult to achieve crystallization of the i-type semiconductor layer at the initial formation stage. The referred to initial formation stage of the i-type semiconductor layer may be represented by, or correspond to, the position P1 (or a portion of the i-type semiconductor layer adjacent the position P1), and the referred to completed formation stage of the i-type semiconductor layer may be represented by, or correspond to, the position P3 (or a portion of the i-type semiconductor layer adjacent the position P3).

On the other hand, in the example 1 where the hydrogen content of the buffer layer is relatively high, crystallinity of the i-type semiconductor layer at the position P1 is approximately 85 % based on the crystallinity of the i-type semiconductor layer at the position P3. Further, in the example 1, the crystallinity of the i-type semiconductor layer at the position P2 is approximately 95 % based on the crystallinity of the i-type semiconductor layer at the position P3.

The crystallinity in the example 1 is greater than the crystallinity in the comparative example at the initial formation stage of the i-type semiconductor layer. In other words, this indicates that the i-type semiconductor layer in the example 1 has the properties similar to microcrystalline silicon at the initial formation stage. In the example 1, a large amount of hydrogen contained in the buffer layer may form seeds for crystal growth at the initial formation stage of the i-type semiconductor layer, and thus, a large number of crystals may be formed at the initial formation stage of the i-type semiconductor layer.

In the example 2 where the hydrogen content of the buffer layer is relatively high, crystallinity of the i-type semiconductor layer at the position P1 is approximately 80 % based on the crystallinity of the i-type semiconductor layer at the position P3. Further, in the example 2, the crystallinity of the i-type semiconductor layer at the position P2 is approximately 93 % based on the crystallinity of the i-type semiconductor layer at the position P3.

In the example 4 where the hydrogen content of the buffer layer is relatively high, crystallinity of the i-type semiconductor layer at the position P1 is approximately 75 % based on the crystallinity of the i-type semiconductor layer at the position P3. Further, in the example 4, the crystallinity of the i-type semiconductor layer at the position P2 is approximately 95 % based on the crystallinity of the i-type semiconductor layer at the position P3.

The hydrogen content of the buffer layer in the example 1 is more than the hydrogen content of the buffer layer in the examples 2 and 4, and the hydrogen content of the buffer layer in the example 2 is more than the hydrogen content of the buffer layer in the example 4.

In the example 3 where the hydrogen content of the buffer layer is relatively low, crystallinity of the i-type semiconductor layer at the position P1 is approximately 53 % based on the crystallinity of the i-type semiconductor layer at the position P3. Further, in the example 3, the crystallinity of the i-type semiconductor layer at the position P2 is approximately 97 % based on the crystallinity of the i-type semiconductor layer at the position P3.

As above, in the example 3 where the hydrogen content of the buffer layer is less than those in the examples 1, 2, and 4, the crystallinity of the i-type semiconductor layer at the initial formation stage is less than those in the examples 1, 2, and 4. However, the crystallinity of the i-type semiconductor layer in the example 3 at the initial formation stage is greater than the crystallinity of the i-type semiconductor layer in the comparative example at the initial formation stage. This indicates that the crystallinity of the i-type semiconductor layer at the initial formation stage can be improved even if a small amount of hydrogen is added to the buffer layer. It is a matter of course that in the example 3, the hydrogen content of the buffer layer is more than the hydrogen content of the i-type semiconductor layer.

In the example 5 where the hydrogen content of the buffer layer is relatively low, the crystallinity of the i-type semiconductor layer at the position P1 is approximately 50 % based on the crystallinity of the i-type semiconductor layer at the position P3. Further, in the example 3, the crystallinity of the i-type semiconductor layer at the position P2 is approximately 88 % based on the crystallinity of the i-type semiconductor layer at the position P3.

The hydrogen content of the buffer layer in the example 3 is more than the hydrogen content of the buffer layer in the example 5.

FIG. 3 illustrates electrical characteristics of each of a comparative example and an example according to the invention. In FIG. 3, the comparative example is substantially the same as the comparative example of FIG. 2, and the example is substantially the same as the example 1 of FIG. 2.

As shown in FIG. 3, in the comparative example, a short circuit current Jsc was approximately 12.60 mA/cm², an open circuit voltage Voc was approximately 0.911 V, a fill factor FF was approximately 0.72 %, and an efficiency Eff was approximately 8.29 %. On the other hand, in the example according to the invention, a short circuit current Jsc was approximately 12.80 mA/cm², an open circuit voltage Voc was approximately 0.943 V, a fill factor FF was approximately 0.73 %, and an efficiency Eff was approximately 8.70 %.

As above, the efficiency Eff in the example according to the invention increased by approximately 4.9 % as compared with the comparative example. In the example according to the invention, the crystallinity of the i-type semiconductor layer at an initial formation stage can increase by adding the buffer layer containing hydrogen, and thus, the crystallinity of the i-type semiconductor layer can be uniform. Hence, the efficiency of the solar cell 10 can be improved.

As above, as the crystallinity of the i-type semiconductor layer increases in the junction portion between the buffer layer and the i-type semiconductor layer, the efficiency of the solar cell 10 may be improved. Considering the description of FIGS. 2 and 3 and the efficiency of the solar cell 10, it may be preferable that the crystallinity of the i-type semiconductor layer in the junction portion between the buffer layer and the i-type semiconductor layer is equal to or greater than 50 % or equal to or greater than 75 % of the crystallinity of the i-type semiconductor layer in the junction portion between the i-type semiconductor layer and the n-type semiconductor layer.

The hydrogen content of the buffer layer is not particularly limited, except that the hydrogen content of the buffer layer is more than the hydrogen content of the i-type semiconductor layer. For example, the hydrogen content of the buffer layer may be substantially equal to or less than hydrogen content of the p-type semiconductor layer. Further, the hydrogen content of the buffer layer may be more than hydrogen content of the p-type semiconductor layer.

As described above with reference to FIG. 2, because it is difficult to form the crystal growth at the initial formation stage of the i-type semiconductor layer, the crystallinity of the i-type semiconductor layer is low. Accordingly, as the thickness of the i-type semiconductor layer decreases, the crystallinity of the i-type semiconductor layer may be relatively low. Considering the thickness of the i-type semiconductor layer, as the thickness of the i-type semiconductor layer adjacent to the buffer layer decreases, it may be preferable that the hydrogen content of the buffer layer helping the crystal growth of the i-type semiconductor layer increases. As the thickness of the i-type semiconductor layer adjacent to the buffer layer increases, it may be preferable that the hydrogen content of the buffer layer helping the crystal growth of the i-type semiconductor layer decreases.

When the hydrogen content of the buffer layer is more than the hydrogen content of the i-type semiconductor layer, it may be preferable that the hydrogen content of the buffer layer may be less than or more than the hydrogen content of the p-type semiconductor layer irrespective of the thickness of the i-type semiconductor layer because the crystallinity of the i-type semiconductor layer may increase. More preferably, the hydrogen content of the buffer layer may be more than the hydrogen content of the p-type semiconductor layer.

In FIG. 2, in the examples 1, 2, and 4, the hydrogen content of the buffer layer is more than the hydrogen content of the i-type semiconductor layer and the hydrogen content of the p-type semiconductor layer. In the examples 3 and 5, the hydrogen content of the buffer layer is more than the hydrogen content of the i-type semiconductor layer and is less than the hydrogen content of the p-type semiconductor layer.

In FIG. 1, the buffer layer 124 containing a relatively large amount of hydrogen helps the crystal growth of the i-type semiconductor layer 122 and thus, can allow the crystallinity of the i-type semiconductor layer 122 to be uniform. However, when a thickness t2 of the buffer layer 124 is excessively large, the buffer layer 124 may block a movement of carriers between the p-type semiconductor layer 121 and the i-type semiconductor layer 122. Hence, the efficiency of the solar cell 10 may be reduced. Accordingly, it may be preferable that the thickness t2 of the buffer layer 124 is sufficiently small. More preferably, the thickness t2 of the buffer layer 124 may be less than a thickness t1 of the i-type semiconductor layer 122.

Further, the thickness t2 of the buffer layer 124 may be substantially equal to or greater than a thickness t3 of the p-type semiconductor layer 121. However, it may be preferable that the thickness t2 of the buffer layer 124 is less than the thickness t3 of the p-type semiconductor layer 121 so as to increase the efficiency of the solar cell 10.

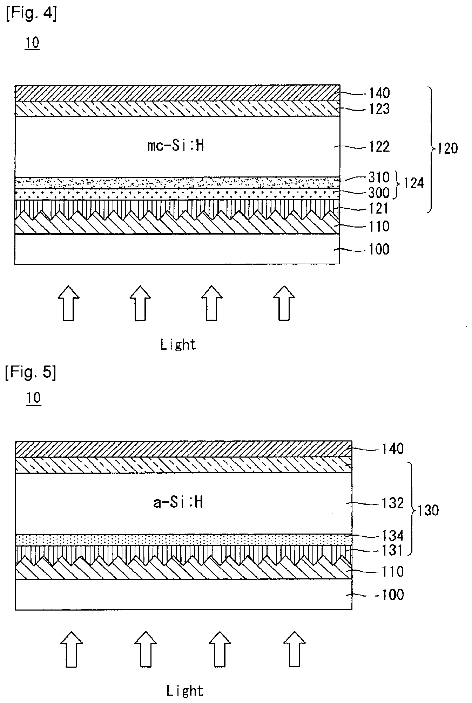

The buffer layer 124 may include a plurality of sub-buffer layers that are positioned adjacent to each other and each have a different hydrogen content. For example, as shown in FIG. 4, the buffer layer 124 may include a first sub-buffer layer 300 adjacent to the p-type semiconductor layer 121 and a second sub-buffer layer 310 adjacent to the i-type semiconductor layer 122.

A hydrogen content of the first sub-buffer layer 300 may be more than a hydrogen content of the second sub-buffer layer 310, and a hydrogen content of the second sub-buffer layer 310 may be more than a hydrogen content of the first sub-buffer layer 300. However, it may be preferable that the hydrogen content of the second sub-buffer layer 310 is more than a hydrogen content of the first sub-buffer layer 300, so that a large number of seeds for helping the crystal growth of the i-type semiconductor layer 122 are formed. The above-described structure of the buffer layer 124 may be achieved by allowing an amount of hydrogen gas injected in a formation process of the first sub-buffer layer 300 to be different from an amount of hydrogen gas injected in a formation process of the second sub-buffer layer 310.

FIG. 5 shows a photoelectric transformation unit 130 using a silicon cell formed of amorphous silicon, for example, hydrogenated amorphous silicon (a-Si:H). In the photoelectric transformation unit 130 of FIG. 5, an i-type semiconductor layer 132 may be formed of amorphous silicon, for example, hydrogenated amorphous silicon (a-Si:H).

As shown in FIG. 5, when the i-type semiconductor layer 132 is formed of amorphous silicon, a buffer layer 134 may be positioned between a p-type semiconductor layer 131 and the i-type semiconductor layer 132. In this case, the buffer layer 134 makes a structure of the i-type semiconductor layer 132 formed of amorphous silicon closer and thus, can improve the efficiency of the solar cell 10.

The crystallinity of the i-type semiconductor layer 132 formed of amorphous silicon is less than the crystallinity of the i-type semiconductor layer 122 formed of microcrystalline silicon. However, the i-type semiconductor layer 132 includes a small amount of crystal material. Accordingly, when the buffer layer 134 is positioned between the p-type semiconductor layer 131 and the i-type semiconductor layer 132, the small amount of crystal material of the i-type semiconductor layer 132 may be uniformly distributed.

Further, because hydrogen contained in the buffer layer 134 increases a density of a layer formed of amorphous silicon when the i-type semiconductor layer 132 formed of amorphous silicon is grown, a density of the i-type semiconductor layer 132 can be improved. Preferably, a hydrogen content of the i-type semiconductor layer 132 formed of amorphous silicon may be approximately 10 % to 11 %, and a hydrogen content of the buffer layer 134 may be approximately 10 % to 11 %.

A method of manufacturing the buffer layer is briefly described below.

The method of manufacturing the buffer layer may be substantially the same as a method of manufacturing the i-type semiconductor layer, except a difference in an amount of hydrogen gas injected in a manufacturing process. More specifically, an amount of hydrogen gas injected into a chamber in the manufacturing process of the buffer layer is more than an amount of hydrogen gas injected into a chamber in the method of manufacturing the i-type semiconductor layer. Thus, a hydrogen content of the buffer layer is more than a hydrogen content of the i-type semiconductor layer.

Considering the above manufacturing method, the hydrogen content of the buffer layer is different from the hydrogen content of the i-type semiconductor layer, but the electrical properties of the buffer layer may be similar to the electrical properties of the i-type semiconductor layer.

In other words, the i-type semiconductor layer may include a first portion and a second portion each containing a different hydrogen content. Further, a hydrogen content of the first portion is more than a hydrogen content of the second portion, and the first portion is positioned between the second portion and the p-type semiconductor layer. A thickness of the first portion is less than a thickness of the second portion, and the first portion may be the buffer layer.

Another method of manufacturing the buffer layer is briefly described below.

Another method of manufacturing the buffer layer may be substantially the same or similar as a method of manufacturing the p-type semiconductor layer except a difference in an amount of hydrogen gas injected in a manufacturing process. More specifically, an amount of hydrogen gas injected into a chamber in the manufacturing process of the buffer layer is more than an amount of hydrogen gas injected into a chamber in the method of manufacturing the p-type semiconductor layer. Thus, a hydrogen content of the buffer layer is more than a hydrogen content of each of the i-type semiconductor layer and the p-type semiconductor layer.

Considering the above manufacturing method, the hydrogen content of the buffer layer is different from the hydrogen content of the p-type semiconductor layer, but the electrical properties of the buffer layer may be similar to the electrical properties of the p-type semiconductor layer.

In other words, the p-type semiconductor layer may include a third portion and a fourth portion each containing a different hydrogen content. Further, a hydrogen content of the fourth portion is more than a hydrogen content of the third portion, and the fourth portion is positioned between the third portion and the i-type semiconductor layer. A thickness of the fourth portion is greater than a thickness of the third portion, and the fourth portion may be the buffer layer.

Further, an amount of impurities of the fourth portion may be different from an amount of impurities of the third portion. Preferably, an amount of p-type impurities of the fourth portion may be less than an amount of p-type impurities of the third portion. In this case, interface characteristic between the p-type semiconductor layer and the i-type semiconductor layer may be improved, and thus, the efficiency of the solar cell may be improved.

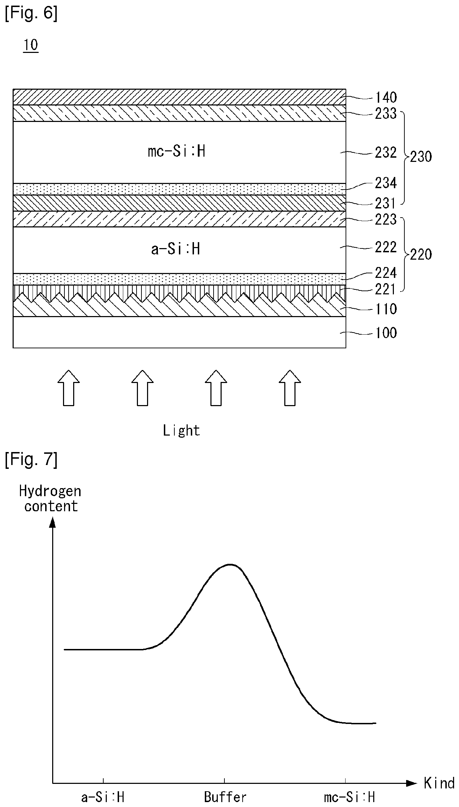

FIGS. 6 to 10 relate to double junction solar cells according to embodiments of the invention. The solar cells shown in FIGS. 6 to 10 may be a double junction solar cell or a pin-pin solar cell. A further description of structures and components identical or equivalent to those illustrated in FIGS. 1 to 5 may be briefly made or may be entirely omitted.

As shown in FIG. 6, a solar cell 10 according to an embodiment of the invention may include a first photoelectric transformation unit 220 including a first i-type semiconductor layer 222 containing amorphous silicon and a second photoelectric transformation unit 230 including a second i-type semiconductor layer 232 containing microcrystalline silicon.

As shown in FIG. 6, in the solar cell 10 according to the embodiment of the invention, a first p-type semiconductor layer 221, a first buffer layer 224, the first i-type semiconductor layer 222, a first n-type semiconductor layer 223, a second p-type semiconductor layer 231, a second buffer layer 234, the second i-type semiconductor layer 232, and a second n-type semiconductor layer 233 are stacked on an light incident surface in the order named.

In the first photoelectric transformation unit 220, all of the first p-type semiconductor layer 221, the first buffer layer 224, the first i-type semiconductor layer 222, and the first n-type semiconductor layer 223 may contain amorphous silicon. In the second photoelectric transformation unit 230, all of the second p-type semiconductor layer 231, the second buffer layer 234, the second i-type semiconductor layer 232, and the second n-type semiconductor layer 233 may contain microcrystalline silicon. Alternatively, the first n-type semiconductor layer 223 of the first photoelectric transformation unit 220 may contain microcrystalline silicon.

The first i-type semiconductor layer 222 may mainly absorb light of a short wavelength band to produce electrons and holes. The second i-type semiconductor layer 232 may mainly absorb light of a long wavelength band to produce electrons and holes.

As above, because the double junction solar cell absorbs light of the short wavelength band and the long wavelength band to produce carriers, the efficiency of the double junction solar cell is high.

Further, a thickness t10 of the second i-type semiconductor layer 232 may be greater than a thickness t20 of the first i-type semiconductor layer 222 so as to sufficiently absorb light of the long wavelength band.

The first photoelectric transformation unit 220 may include the first p-type semiconductor layer 221, the first buffer layer 224, the first i-type semiconductor layer 222, and the first n-type semiconductor layer 223. A hydrogen content of the first buffer layer 224 may be more than a hydrogen content of the first i-type semiconductor layer 222. The hydrogen content of the first buffer layer 224 may be different from a hydrogen content of the first p-type semiconductor layer 221. The hydrogen content of the first buffer layer 224, the hydrogen content of the first i-type semiconductor layer 222, and the hydrogen content of the first p-type semiconductor layer 221 are below described in detail.

Further, it may be preferable that a thickness t21 of the first buffer layer 224 is less than the thickness t20 of the first i-type semiconductor layer 222.

The second photoelectric transformation unit 230 may include the second p-type semiconductor layer 231, the second buffer layer 234, the second i-type semiconductor layer 232, and the second n-type semiconductor layer 233. A hydrogen content of the second buffer layer 234 may be more than a hydrogen content of the second i-type semiconductor layer 232. The hydrogen content of the second buffer layer 234 may be different from a hydrogen content of the second p-type semiconductor layer 231. The hydrogen content of the second buffer layer 234, the hydrogen content of the second i-type semiconductor layer 232, and the hydrogen content of the second p-type semiconductor layer 231 are below described in detail.

In the second photoelectric transformation unit 230, it may be preferable that crystallinity of the second i-type semiconductor layer 232 in a junction portion between the second buffer layer 234 and the second i-type semiconductor layer 232 is equal to or greater than approximately 50 % or equal to or greater than approximately 75 % of crystallinity of the second i-type semiconductor layer 232 in a junction portion between the second i-type semiconductor layer 232 and the second n-type semiconductor layer 233.

Further, it may be preferable that a thickness t11 of the second buffer layer 234 is less than the thickness t10 of the second i-type semiconductor layer 232.

The thickness t21 of the first buffer layer 224 may be equal to or different from the thickness t11 of the second buffer layer 234. The thickness t11 of the second buffer layer 234 may be greater than the thickness t21 of the first buffer layer 224 considering that the thickness t20 of the first i-type semiconductor layer 222 is less than the thickness t10 of the second i-type semiconductor layer 232.

The hydrogen content of the first buffer layer 224 may be equal to or different from the hydrogen content of the second buffer layer 234.

Crystallinity of the first i-type semiconductor layer 222 formed of amorphous silicon may be less than crystallinity of the second i-type semiconductor layer 232 formed of microcrystalline silicon. Because hydrogen helps the crystal growth to increase crystallinity, the hydrogen content of the second buffer layer 234 adjacent to the second i-type semiconductor layer 232 may be more than the hydrogen content of the first buffer layer 224 adjacent to the first i-type semiconductor layer 222.

As the thickness of the i-type semiconductor layer decreases, the density and the uniformity of the i-type semiconductor layer may be reduced because of characteristics of the manufacturing process. In this case, hydrogen may increase the density and the uniformity of the i-type semiconductor layer. Considering this, the hydrogen content of the first buffer layer 224 may be more than the hydrogen content of the second buffer layer 234. Preferably, when the thickness t20 of the first i-type semiconductor layer 222 is sufficiently less than the thickness t10 of the second i-type semiconductor layer 232, the hydrogen content of the first buffer layer 224 may be more than the hydrogen content of the second buffer layer 234. In this case, the hydrogen content of the first buffer layer 224 may be more than the hydrogen content of the first p-type semiconductor layer 221, and the hydrogen content of the second buffer layer 234 may be less than the hydrogen content of the second p-type semiconductor layer 231.

The hydrogen content of the first i-type semiconductor layer 222 formed of amorphous silicon may be more than the hydrogen content of the second i-type semiconductor layer 232 formed of microcrystalline silicon. The difference is caused by property difference between amorphous silicon and microcrystalline silicon.

FIG. 7 is a graph comparing hydrogen contents of the first i-type semiconductor layer 222, the second i-type semiconductor layer 232, the first buffer layer 224, and the second buffer layer 234.

As shown in FIG. 7, the hydrogen content of each of the first and second buffer layers 224 and 234 is a maximum value, the hydrogen content of the second i-type semiconductor layer 232 is a minimum value, and the hydrogen content of the first i-type semiconductor layer 222 is less than the hydrogen contents of the first and second buffer layers 224 and 234 and is more than the hydrogen content of the second i-type semiconductor layer 232.

The hydrogen content of the first buffer layer 224 may be different from the hydrogen content of the second buffer layer 234. However, because a difference between the hydrogen content of the first buffer layer 224 and the hydrogen content of the second buffer layer 234 is much less than a difference between the hydrogen content of the first i-type semiconductor layer 222 and the hydrogen content of the second i-type semiconductor layer 232, the hydrogen content of the first buffer layer 224 and the hydrogen content of the second buffer layer 234 are not distinguished in FIG. 7.

For example, the hydrogen content of the first i-type semiconductor layer 222 formed of amorphous silicon may be approximately 11.4 %, and the hydrogen content of the second i-type semiconductor layer 232 formed of microcrystalline silicon may be approximately 4.8 %. Thus, the difference may be approximately 7 to 8 %. Further, the hydrogen content of the first buffer layer 224 may be approximately 18.7 %, and the hydrogen content of the second buffer layer 234 may be approximately 17.9 %. Thus, the difference may be relatively small value. As above, the difference between the hydrogen content of the second i-type semiconductor layer 232 and the hydrogen content of the second buffer layer 234 may be greater than the difference between the hydrogen content of the first i-type semiconductor layer 222 and the hydrogen content of the first buffer layer 224.

Because the crystallinity of the second i-type semiconductor layer 232 formed of microcrystalline silicon may be greater than the crystallinity of the first i-type semiconductor layer 222, a relatively large amount of hydrogen may be contained in the second buffer layer 234 so as to produce a large amount of seeds helping silicon crystal growth. Further, because microcrystalline silicon of FIG. 7 contains a relatively small amount of hydrogen because of the properties of microcrystalline silicon, a difference between the hydrogen content of the second i-type semiconductor layer 232 and the hydrogen content of the second buffer layer 234 is relatively large.

On the other hand, as shown in FIG. 7, the hydrogen content of the first i-type semiconductor layer 222 may be more than the hydrogen content of the second i-type semiconductor layer 232 because of the properties of amorphous silicon. Thus, even if the hydrogen content of the first buffer layer 224 increases, the difference between the hydrogen content of the first i-type semiconductor layer 222 and the hydrogen content of the first buffer layer 224 may be less than the difference between the hydrogen content of the second i-type semiconductor layer 232 and the hydrogen content of the second buffer layer 234, so as to increase the density of the first i-type semiconductor layer 222.

If the difference between the hydrogen content of the first i-type semiconductor layer 222 and the hydrogen content of the first buffer layer 224 is greater than the difference between the hydrogen content of the second i-type semiconductor layer 232 and the hydrogen content of the second buffer layer 234, the hydrogen content of the first buffer layer 224 may excessively increase. Hence, the efficiency of the solar cell 10 may be reduced.

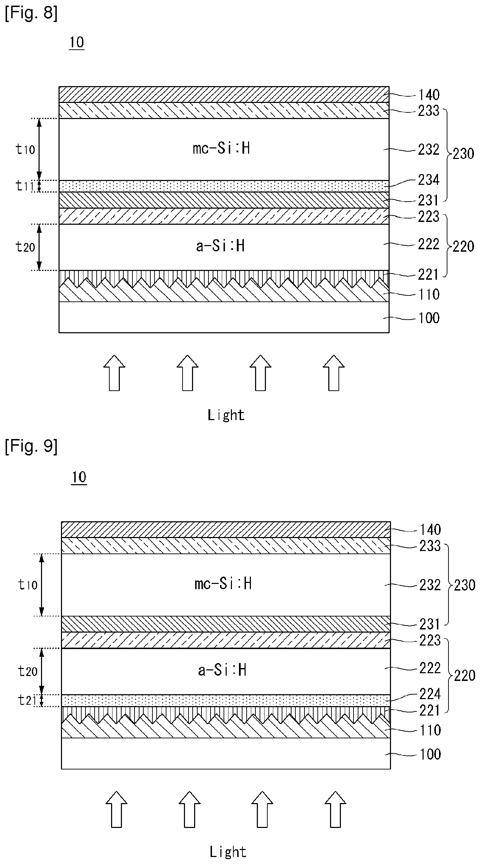

Further, the first photoelectric transformation unit 220 and the second photoelectric transformation unit 230 may respectively include the first buffer layer 224 and the second buffer layer 234 as shown in FIG. 6. However, as shown in FIG. 8, the first buffer layer 224 may be omitted in the first photoelectric transformation unit 220. Further, as shown in FIG. 9, the second buffer layer 234 may be omitted in the second photoelectric transformation unit 230.

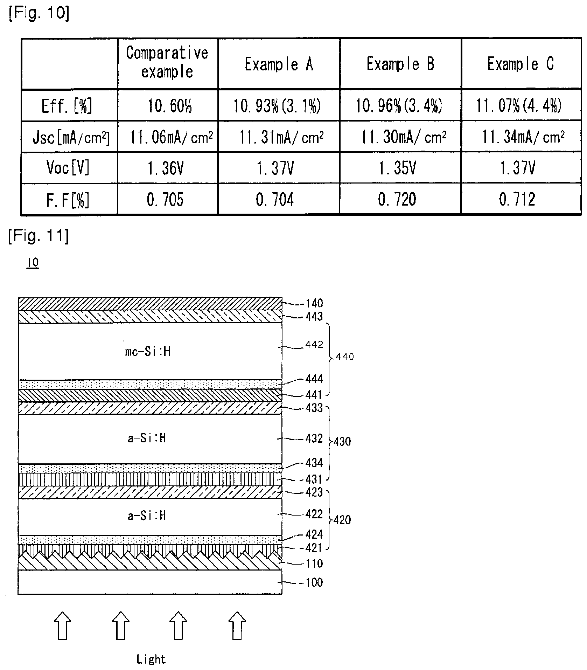

FIG. 10 is a table illustrating electrical characteristics of each of a comparative example and examples A, B, and C. In FIG. 10, the comparative example is an example where a buffer layer is not formed in a double junction solar cell, the example A is an example of the solar cell illustrated in FIG. 9, the example B is an example of the solar cell illustrated in FIG. 8, and the example C is an example of the solar cell illustrated in FIG. 6.

As shown in FIG. 10, in the comparative example, a short circuit current Jsc was approximately 11.06 mA/cm², an open circuit voltage Voc was approximately 1.36 V, a fill factor FF was approximately 0.705 %, and an efficiency Eff was approximately 10.60 %.

On the other hand, in the example A according to the invention, a short circuit current Jsc was approximately 11.31 mA/cm², an open circuit voltage Voc was approximately 1.37 V, a fill factor FF was approximately 0.704 %, and an efficiency Eff was approximately 10.93 %. As above, the efficiency Eff in the example A according to the invention increased by approximately 3.1 % as compared with the comparative example. Because the density of the first i-type semiconductor layer 222 increases by adding the first buffer layer 224 to the first photoelectric transformation unit 220 as shown in FIG. 9, the efficiency Eff in the example A was improved.

Further, in the example B according to the invention, a short circuit current Jsc was approximately 11.30 mA/cm², an open circuit voltage Voc was approximately 1.35 V, a fill factor FF was approximately 0.720 %, and an efficiency Eff was approximately 10.96 %. As above, the efficiency Eff in the example B according to the invention increased by approximately 3.4 % as compared with the comparative example. In the example B according to the invention, the crystallinity of the second i-type semiconductor layer 232 may increase at an initial formation stage of the second i-type semiconductor layer 232 by adding the second buffer layer 234 to the second photoelectric transformation unit 230, and thus, the crystallinity of the second i-type semiconductor layer 232 may be uniform. Hence, the efficiency of the solar cell may be improved.

Further, in the example C according to the invention, a short circuit current Jsc was approximately 11.34 mA/cm², an open circuit voltage Voc was approximately 1.37 V, a fill factor FF was approximately 0.712 %, and an efficiency Eff was approximately 11.07 %. As above, the efficiency Eff in the example C according to the invention increased by approximately 4.4 % as compared with the comparative example. The efficiency Eff in the example C was further improved by forming the first buffer layer 224 in the first photoelectric transformation unit 220 and forming the second buffer layer 234 in the second photoelectric transformation unit 230 as shown in FIG. 6.

Further, as shown in FIG. 4, at least one of the first buffer layer 224 and the second buffer layer 234 may be positioned adjacent to each other and may include a plurality of sub-buffer layers having each a different hydrogen content.

For example, when the thickness t11 of the second buffer layer 234 is greater than the thickness t21 of the first buffer layer 224, it may be preferable that the second buffer layer 234 may include a plurality of sub-buffer layers and the first buffer layer 224 has a single-layered structure as shown in FIG. 4.

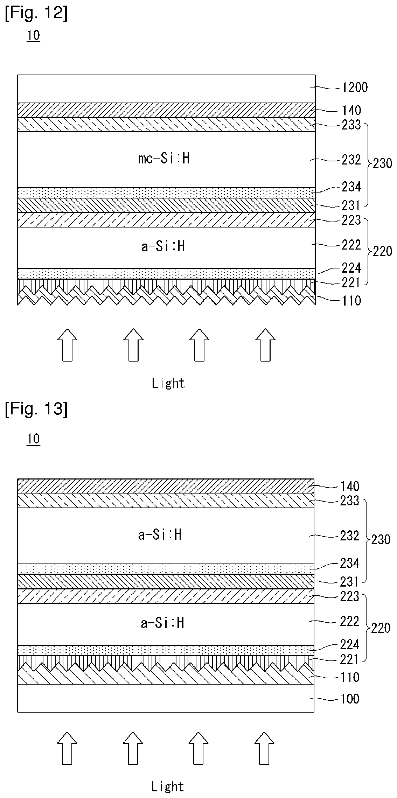

FIGS. 11 and 12 illustrate other structures of solar cells according to embodiments of the invention. A further description of structures and components identical or equivalent to those described above may be briefly made or may be entirely omitted.

FIG. 11 illustrates a triple junction solar cell 10 according to an embodiment of the invention. The solar cell shown in FIG. 11 may have a pin-pin-pin structure.

As shown in FIG. 11, the solar cell 10 according to the embodiment of the invention may include a first photoelectric transformation unit 420, a second photoelectric transformation unit 430, and a third photoelectric transformation unit 440 that are stacked on an light incident surface, i.e., a substrate 100 in the order named.

The first photoelectric transformation unit 420 may include a first p-type semiconductor layer 421, a first buffer layer 424, a first i-type semiconductor layer 422, and a first n-type semiconductor layer 423. A hydrogen content of the first buffer layer 424 may be more than a hydrogen content of the first i-type semiconductor layer 422.

The second photoelectric transformation unit 430 may include a second p-type semiconductor layer 431, a second buffer layer 434, a second i-type semiconductor layer 432, and a second n-type semiconductor layer 433. A hydrogen content of the second buffer layer 434 may be more than a hydrogen content of the second i-type semiconductor layer 432.

The third photoelectric transformation unit 440 may include a third p-type semiconductor layer 441, a third buffer layer 444, a third i-type semiconductor layer 442, and a third n-type semiconductor layer 443. A hydrogen content of the third buffer layer 444 may be more than a hydrogen content of the third i-type semiconductor layer 442.

The first photoelectric transformation unit 420 may be an amorphous silicon cell using amorphous silicon (a-Si), for example, hydrogenated amorphous silicon (a-Si:H). The first i-type semiconductor layer 422 of the first photoelectric transformation unit 420 may be formed of hydrogenated amorphous silicon (a-Si:H) and may absorb light of a short wavelength band to produce power.

The second photoelectric transformation unit 430 may be an amorphous silicon cell using amorphous silicon (a-Si), for example, hydrogenated amorphous silicon (a-Si:H). The second i-type semiconductor layer 432 of the second photoelectric transformation unit 430 may be formed of hydrogenated amorphous silicon (a-Si:H) and may absorb light of a middle wavelength band between a short wavelength band and a long wavelength band to produce power.

The third photoelectric transformation unit 440 may be an amorphous silicon cell using microcrystalline silicon (mc-Si), for example, hydrogenated microcrystalline silicon (mc-Si:H). The third i-type semiconductor layer 442 of the third photoelectric transformation unit 440 may be formed of hydrogenated microcrystalline silicon (mc-Si:H) and may absorb light of a long wavelength band to produce power.

A thickness of the third i-type semiconductor layer 442 may be greater than a thickness of the second i-type semiconductor layer 432, and the thickness of the second i-type semiconductor layer 432 may be greater than a thickness of the first i-type semiconductor layer 422.

As shown in FIG. 12, a substrate 1200 may be positioned opposite a light incident surface. More specifically, a second n-type semiconductor layer 233, a second i-type semiconductor layer 232, a second buffer layer 234, a second p-type semiconductor layer 231, a first n-type semiconductor layer 223, a first i-type semiconductor layer 222, a first buffer layer 224, and a first p-type semiconductor layer 221 may be positioned on the substrate 1200 in the order named.

In such a structure shown in FIG. 12, because light is incident on the opposite side of the substrate 1200, i.e., on a front electrode 110, the substrate 1200 does not need to be transparent. Thus, the substrate 1200 may be formed of metal in addition to glass and plastic. The solar cell 10 having the structure shown in FIG. 12 may be called a nip-type solar cell. Further, although it is not shown in FIG. 12, the solar cell according to the invention may further include a reflective layer capable of reflecting transmitted light.

Further, although it is not shown, in case the solar cell according to the invention may include a plurality of photoelectric transformation units (for example, in case of a double junction solar cell or a triple junction solar cell), an interlayer may be positioned between two adjacent photoelectric transformation units. The interlayer may reduce a thickness of the i-type semiconductor layer to improve the efficiency of the stability.

FIGS. 13 to 16 illustrate other structures of solar cells according to embodiments of the invention. A further description of structures and components identical or equivalent to those described above may be briefly made or may be entirely omitted.

As shown in FIG. 13, the solar cell 10 useful for the understanding of the invention may include a first photoelectric transformation unit 220 including a first i-type semiconductor layer 222 containing amorphous silicon and a second photoelectric transformation unit 230 including a second i-type semiconductor layer 235 containing amorphous silicon. In other words, both the first i-type semiconductor layer 222 and the second i-type semiconductor layer 235 may contain amorphous silicon.

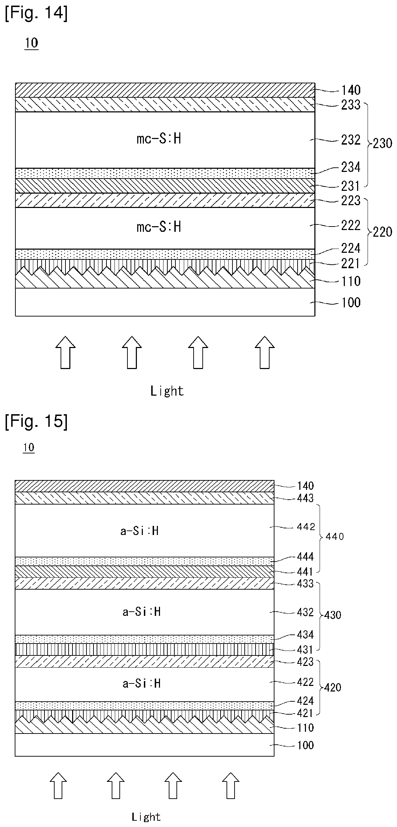

Alternatively, as shown in FIG. 14, the solar cell 10 according to the embodiment of the invention may include a first photoelectric transformation unit 220 including a first i-type semiconductor layer 225 containing microcrystalline silicon and a second photoelectric transformation unit 230 including a second i-type semiconductor layer 232 containing microcrystalline silicon. In other words, both the first i-type semiconductor layer 225 and the second i-type semiconductor layer 232 may contain microcrystalline silicon.

Alternatively, as shown in FIG. 15, the solar cell useful for the understanding of the invention may include a first photoelectric transformation unit 420, a second photoelectric transformation unit 430, and a third photoelectric transformation unit 440, each of which contains amorphous silicon. In other words, all of a first i-type semiconductor layer 422, a second i-type semiconductor layer 432, and a third i-type semiconductor layer 445 may contain amorphous silicon.

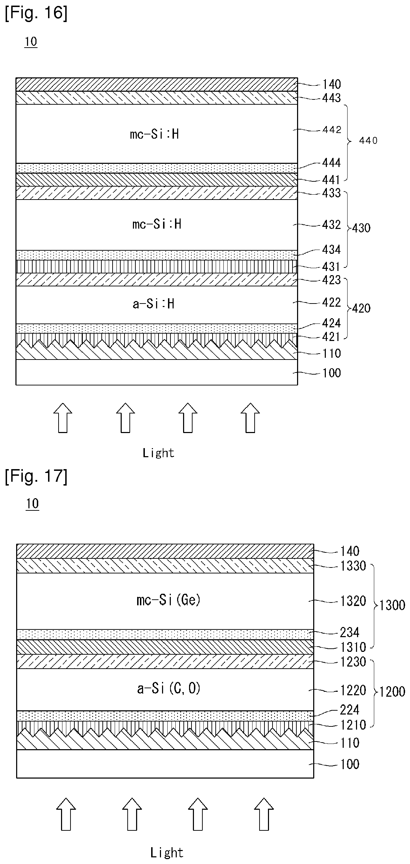

Alternatively, as shown in FIG. 16, the solar cell 10 according to the embodiment of the invention may include a first photoelectric transformation unit 420 formed of amorphous silicon, a second photoelectric transformation unit 430 formed of microcrystalline silicon, and a third photoelectric transformation unit 440 formed of microcrystalline silicon. In other words, a first i-type semiconductor layer 422 may contain amorphous silicon, and a second i-type semiconductor layer 435 and a third i-type semiconductor layer 442 may contain microcrystalline silicon.

FIGS. 17 to 32 relate to examples of doping intrinsic semiconductor layers with impurities according to embodiments of the invention. A further description of structures and components identical or equivalent to those described above may be briefly made or may be entirely omitted.

As shown in FIG. 17, photoelectric transformation units 1200 and 1300 of the solar cell 10 according to the embodiment of the invention may include a first i-type semiconductor layer 1220 doped with at least one of carbon (C) and oxygen (O) as impurities and a second i-type semiconductor layer 1320 doped with germanium (Ge)-doped microcrystalline silicon (mc-Si(Ge)), so as to improve the efficiency of the solar cell 10 by adjusting their band gaps.

Preferably, the photoelectric transformation units 1200 and 1300 may include the first photoelectric transformation unit 1200 and the second photoelectric transformation unit 1300.

The first photoelectric transformation unit 1200 may be an amorphous silicon cell using amorphous silicon (a-Si), for example, hydrogenated amorphous silicon (a-Si:H).

Because the first i-type semiconductor layer 1220 may be doped with at least one of carbon and oxygen as impurities, a band gap of the first i-type semiconductor layer 1220 may increase by doped carbon and oxygen. Hence, an absorbance of the first i-type semiconductor layer 1220 with respect to light of a short wavelength band may increase, and the efficiency of the solar cell 10 may be improved.

In the first photoelectric transformation unit 1200, at least one of the first p-type semiconductor layer 1210 and the first n-type semiconductor layer 1230 may be doped with at least one of carbon (C) and oxygen (O) under condition that the first i-type semiconductor layer 1220 is doped with at least one of carbon (C) and oxygen (O). Preferably, the first p-type semiconductor layer 1210 may be doped with at least one of carbon (C) and oxygen (O).

A first buffer layer 224 may contain at least one of carbon (C) and oxygen (O) considering that the first buffer layer 224 may be formed during a manufacturing process of the first i-type semiconductor layer 1220.

The second photoelectric transformation unit 1300 may be a silicon cell using microcrystalline silicon (mc-Si), for example, hydrogenated microcrystalline silicon (mc-Si:H).

The second i-type semiconductor layer 1320 of the second photoelectric transformation unit 1300 may be doped with Ge as impurities. Germanium may reduce a band gap of the second i-type semiconductor layer 1320. Accordingly, an absorbance of the second i-type semiconductor layer 1320 with respect to the light of a long wavelength band may increase, and thus the efficiency of the solar cell 10 may be improved.

For example, a plasma enhanced chemical vapor deposition (PECVD) method may be used to dope the second i-type semiconductor layer 1320 with Ge. In the PECVD method, a very high frequency (VHF), a high frequency (HF), or a radio frequency (RF) may be applied to a chamber filled with Ge gas.

In the second photoelectric transformation unit 1300, at least one of the second p-type semiconductor layer 1310 and the second n-type semiconductor layer 1330 may be doped with Ge under condition that the second i-type semiconductor layer 1320 is doped with Ge. Preferably, both the second p-type semiconductor layer 1310 and the second n-type semiconductor layer 1330 may be doped with Ge.

A second buffer layer 234 may contain Ge considering that the second buffer layer 234 may be formed during a manufacturing process of the second i-type semiconductor layer 1320.

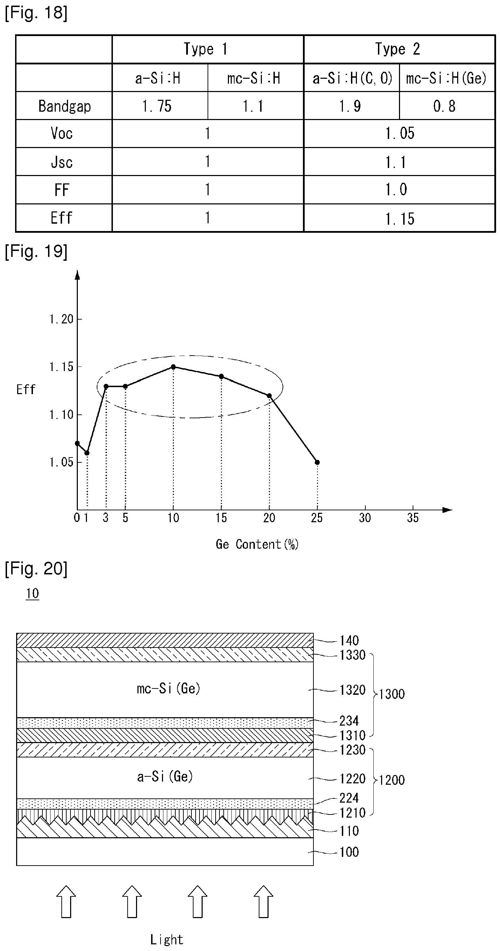

FIG. 18 illustrates a type 1 solar cell where first and second i-type semiconductor layers are not doped with carbon (C), oxygen (O), and Ge, and a type 2 solar cell where a first i-type semiconductor layer is doped with at least one of carbon (C) and oxygen (O) as impurities and a second i-type semiconductor layer is doped with Ge.

As shown in FIG.18, in the type 1 solar cell, the first i-type semiconductor layer is formed of hydrogenated amorphous silicon (a-Si:H), and the second i-type semiconductor layer is formed of hydrogenated microcrystalline silicon (mc-Si:H). In the type 2 solar cell, as in the embodiment of the invention, the first i-type semiconductor layer is formed of hydrogenated amorphous silicon (a-Si:H(C,O)) doped with at least one of carbon (C) and oxygen (O), and the second i-type semiconductor layer is formed of Ge-doped hydrogenated microcrystalline silicon (mc-Si:H(Ge)).

In the type 1 solar cell, a band gap of the first i-type semiconductor layer is 1.75 eV, and a band gap of the second i-type semiconductor layer is 1.1 eV.

Further, in the type 1 solar cell, an open circuit voltage Voc is approximately 1 V, a short circuit current Jsc is approximately 1 mA/cm², a fill factor FF is approximately 1, and an efficiency Eff is approximately 1. Characteristics Voc, Jsc, FF, and Eff of the type 1 solar cell are set, so that the type 1 solar cell and the type 2 solar cell are compared with each other.

On the other hand, in the type 2 solar cell, a band gap of the first i-type semiconductor layer is 1.9 eV and is greater than that in the type 1 solar cell by approximately 0.15 eV. A band gap of the second i-type semiconductor layer is 0.8 eV and is less than that in the type 1 solar cell by about 0.3 eV.

Further, in the type 2 solar cell, an open circuit voltage Voc is approximately 1.05 V, a short circuit current Jsc is approximately 1.1 mA/cm², a fill factor FF is approximately 1.0, and an efficiency Eff is approximately 1.15.

As above, in the type 2 solar cell, because the first i-type semiconductor layer is formed of hydrogenated amorphous silicon (a-Si:H(C,O)) doped with at least one of carbon (C) and oxygen (O) and the second i-type semiconductor layer is formed of Ge-doped hydrogenated microcrystalline silicon (mc-Si:H(Ge)), the band gap of the second i-type semiconductor layer while increasing the band gap of the first i-type semiconductor layer may be reduced. Hence, the efficiency of the solar cell 10 may be improved.

FIG. 19 is a graph illustrating the efficiency of a solar cell depending on a Ge content of a second i-type semiconductor layer.

As shown in FIG. 19, when the Ge content of the second i-type semiconductor layer is 0 to 1 atom%, the efficiency of the solar cell is approximately 1.06 to 1.07. In this case, the band gap of the second i-type semiconductor layer may not be sufficiently reduced because of a small amount of Ge.

On the other hand, when the Ge content of the second i-type semiconductor layer is 3 to 20 atom%, the efficiency of the solar cell has a sufficiently improved value of approximately 1.12 to 1.15. In this case, the band gap of the second i-type semiconductor layer may be sufficiently reduced because of the sufficient Ge content. Hence, an absorbance of the second i-type semiconductor layer with respect to light of a long wavelength band may increase.

On the other hand, when the Ge content of the second i-type semiconductor layer is 25 atom%, the efficiency of the solar cell has a reduced value of approximately 1.05. In this case, a portion of Ge may operate as a defect inside the second i-type semiconductor layer because of an excessively large amount of Ge. As a result, the efficiency of the solar cell may be reduced in spite of an increase in the Ge content.

Considering the description of FIG. 19, it may be preferable that the Ge content of the second i-type semiconductor layer is approximately 3 to 20 atom%.

Strontium (Sr) may replace Ge contained in the second i-type semiconductor layer. In other words, even if the second i-type semiconductor layer is doped with Sr, a band gap of the second i-type semiconductor layer may be sufficiently reduced.

As shown in FIG. 20, the first i-type semiconductor layer 1220 may be doped with Ge as impurities. In this case, the band gap of the first i-type semiconductor layer 1220 may be reduced because of Ge. Hence, an absorbance of the first i-type semiconductor layer 1220 with respect to light of a long wavelength band may increase, and the efficiency of the solar cell 10 may be improved as compared with a related art solar cell.

As shown in FIG. 20, the solar cell according to the embodiment of the invention includes an i-type semiconductor layer formed of amorphous silicon (i.e., the first i-type semiconductor layer 1220) positioned between the front electrode 110 and the rear electrode 140 and an i-type semiconductor layer formed of microcrystalline silicon (i.e., the second i-type semiconductor layer 1320) positioned between the front electrode 110 and the rear electrode 140. The i-type semiconductor layer formed of amorphous silicon and the i-type semiconductor layer formed of microcrystalline silicon may be doped with the same material, i.e., Ge.

In this case, in the first photoelectric transformation unit 1200, at least one of the first p-type semiconductor layer 1210 and the first n-type semiconductor layer 1230 may be doped with Ge under condition that the first i-type semiconductor layer 1220 is doped with Ge. Preferably, both the first p-type semiconductor layer 1210 and the first n-type semiconductor layer 1230 may be doped with Ge.

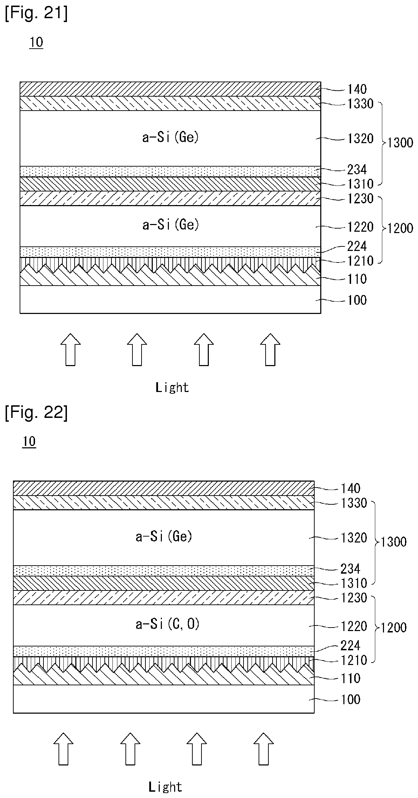

Further, as shown in FIG. 21, both the first photoelectric transformation unit 1200 and the second photoelectric transformation unit 1300 may be an amorphous silicon cell using amorphous silicon (a-Si), for example, hydrogenated amorphous silicon (a-Si:H). In this case, both the first i-type semiconductor layer 1220 and the second i-type semiconductor layer 1321 may contain amorphous silicon and may be doped with Ge.

Further, as shown in FIG. 22, both the first photoelectric transformation unit 1200 and the second photoelectric transformation unit 1300 may be an amorphous silicon cell using amorphous silicon (a-Si), for example, hydrogenated amorphous silicon (a-Si:H). In this case, the first i-type semiconductor layer 1221 formed of amorphous silicon may be doped with at least one of carbon (C) and oxygen (O), and the second i-type semiconductor layer 1321 formed of amorphous silicon may be doped with Ge.

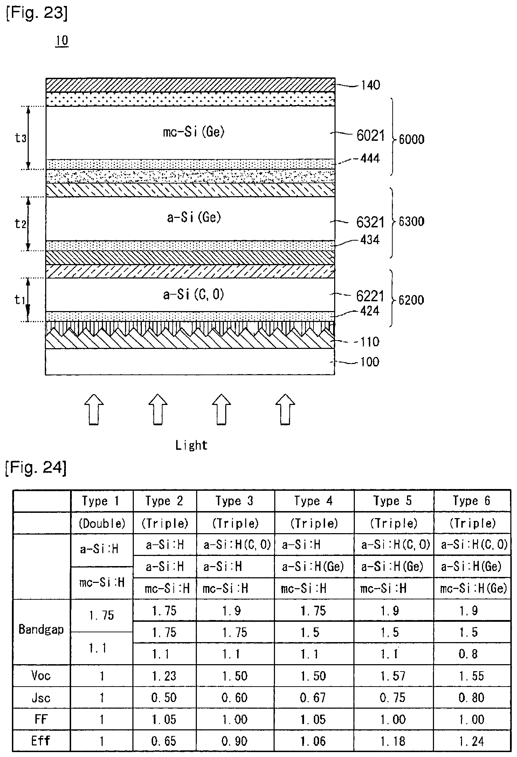

As shown in FIG. 23, the solar cell 10 according to the embodiment of the invention includes first, second, and third photoelectric transformation units 6200, 6300, and 6000. The first photoelectric transformation unit 6200 includes a first i-type semiconductor layer 6221 formed of amorphous silicon (a-Si(C, O)) doped with at least one of carbon (C) and oxygen (O) as impurities. The second photoelectric transformation unit 6300 includes a second i-type semiconductor layer 6321 formed of Ge-doped amorphous silicon (a-Si(Ge)). The third photoelectric transformation unit 6000 includes a third i-type semiconductor layer 6021 formed of Ge-doped microcrystalline silicon (mc-Si(Ge)).

The first photoelectric transformation unit 6200 may be an amorphous silicon cell using amorphous silicon (a-Si(C, O)) doped with at least one of carbon (C) and oxygen (O) as impurities, for example, hydrogenated amorphous silicon (a-Si:H(C, O)).

The second photoelectric transformation unit 6300 may be an amorphous silicon cell using Ge-doped amorphous silicon (a-Si(Ge)), for example, hydrogenated Ge-doped amorphous silicon (a-Si:H(Ge)).

The third photoelectric transformation unit 6000 may be a microcrystalline silicon cell using Ge-doped microcrystalline silicon (mc-Si(Ge)), for example, hydrogenated Ge-doped microcrystalline silicon (mc-Si:H(Ge)).

A thickness t3 of the third i-type semiconductor layer 6021 may be greater than a thickness t2 of the second i-type semiconductor layer 6321, and the thickness t2 of the second i-type semiconductor layer 6321 may be greater than a thickness t1 of the first i-type semiconductor layer 6221.

FIG. 24 is a table illustrating characteristics of a solar cell depending on a structure of a photoelectric transformation unit.

In FIG. 24, a type 1 solar cell has a double junction structure including a first i-type semiconductor layer formed of hydrogenated amorphous silicon (a-Si:H) and a second i-type semiconductor layer formed of hydrogenated microcrystalline silicon (mc-Si:H). A type 2 solar cell has a triple junction structure including a first i-type semiconductor layer formed of hydrogenated amorphous silicon (a-Si:H), a second i-type semiconductor layer formed of hydrogenated amorphous silicon (a-Si:H), and a third i-type semiconductor layer formed of hydrogenated microcrystalline silicon (mc-Si:H). A type 3 solar cell has a triple junction structure including a first i-type semiconductor layer formed of hydrogenated amorphous silicon (a-Si:H(C, O)) doped with at least one of carbon (C) and oxygen (O) as impurities, a second i-type semiconductor layer formed of hydrogenated amorphous silicon (a-Si:H), and a third i-type semiconductor layer formed of hydrogenated microcrystalline silicon (mc-Si:H). A type 4 solar cell has a triple junction structure including a first i-type semiconductor layer formed of hydrogenated amorphous silicon (a-Si:H), a second i-type semiconductor layer formed of Ge-doped hydrogenated amorphous silicon (a-Si:H(Ge)), and a third i-type semiconductor layer formed of hydrogenated microcrystalline silicon (mc-Si:H). A type 5 solar cell has a triple junction structure including a first i-type semiconductor layer formed of hydrogenated amorphous silicon (a-Si:H(C, O)) doped with at least one of carbon (C) and oxygen (O) as impurities, a second i-type semiconductor layer formed of Ge-doped hydrogenated amorphous silicon (a-Si:H(Ge)), and a third i-type semiconductor layer formed of hydrogenated microcrystalline silicon (mc-Si:H). A type 6 solar cell, as in the embodiment of the invention, has a triple junction structure including a first i-type semiconductor layer formed of hydrogenated amorphous silicon (a-Si:H(C, O)) doped with at least one of carbon (C) and oxygen (O) as impurities, a second i-type semiconductor layer formed of Ge-doped hydrogenated amorphous silicon (a-Si:H(Ge)), and a third i-type semiconductor layer formed of Ge-doped hydrogenated microcrystalline silicon (mc-Si:H(Ge)).

In FIG. 24, characteristics Voc, Jsc, FF, and Eff of the type 1 solar cell are set, so that the type 1 solar cell and the types 2 to 6 solar cells are compared with one another. The efficiency Eff of the type 1 solar cell having the double junction structure is 1, and the efficiency Eff of the types 2 to 5 solar cells each having the triple junction structure is approximately 0.65 to 1.18.

Further, the efficiency Eff of the type 6 solar cell is approximately 1.24 and is much greater than the efficiency Eff of the types 1 to 5 solar cells. More specifically, in the type 6 solar cell, a band gap of the first i-type semiconductor layer is approximately 1.9 eV, and thus, an absorbance of the first i-type semiconductor layer with respect to light of a short wavelength band may increase. Further, a band gap of the second i-type semiconductor layer is approximately 1.5 eV, and thus, an absorbance of the second i-type semiconductor layer with respect to light of middle wavelength band may increase. Further, a band gap of the third i-type semiconductor layer is approximately 0.8 eV, and thus, an absorbance of the third i-type semiconductor layer with respect to light of a long wavelength band may increase. As a result, the efficiency of the type 6 solar cell may be improved.

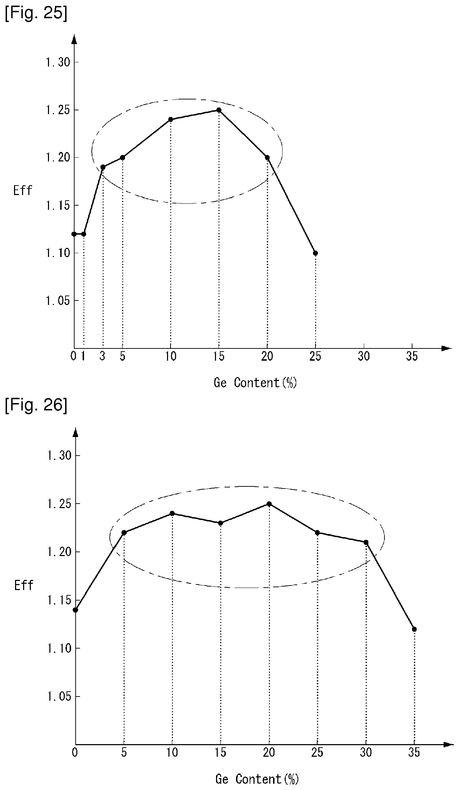

FIG. 25 is a graph illustrating the efficiency of a solar cell depending on a Ge content of a third i-type semiconductor layer. More specifically, FIG. 25 is a graph illustrating the efficiency of a solar cell depending on a Ge content of a third i-type semiconductor layer when a Ge content of a second i-type semiconductor layer is approximately 20 atom% and a carbon content of a first i-type semiconductor layer is approximately 20 atom%.

As shown in FIG. 25, when the Ge content of the third i-type semiconductor layer is 0 to 1 atom%, the efficiency of the solar cell is approximately 1.12. In this case, a band gap of the third i-type semiconductor layer may not be sufficiently reduced because of a small amount of Ge.

On the other hand, when the Ge content of the third i-type semiconductor layer is 3 to 20 atom%, the efficiency of the solar cell has a sufficiently improved value of approximately 1.19 to 1.25. In this case, the band gap of the third i-type semiconductor layer may be sufficiently reduced because of the sufficient Ge content. Hence, an absorbance of the third i-type semiconductor layer with respect to light of a long wavelength band may increase.

On the other hand, when the Ge content of the third i-type semiconductor layer is 25 atom%, the efficiency of the solar cell has a reduced value of approximately 1.10. In this case, a portion of Ge may operate as a defect inside the third i-type semiconductor layer because of an excessively large amount of Ge. As a result, the efficiency of the solar cell may be reduced in spite of an increase in the Ge content.

Considering the description of FIG. 25, it may be preferable that the Ge content of the third i-type semiconductor layer is approximately 3 to 20 atom%.

FIG. 26 is a graph illustrating the efficiency of a solar cell depending on a Ge content of a second i-type semiconductor layer. More specifically, FIG. 26 is a graph illustrating the efficiency of a solar cell depending on a Ge content of a second i-type semiconductor layer when a Ge content of a third i-type semiconductor layer is approximately 15 atom% and a carbon content of a first i-type semiconductor layer is approximately 20 atom%.

As shown in FIG. 26, when the second i-type semiconductor layer is not doped with Ge, the efficiency of the solar cell is approximately 1.14.

On the other hand, when the Ge content of the second i-type semiconductor layer is 5 to 30 atom%, the efficiency of the solar cell has a sufficiently improved value of approximately 1.21 to 1.25. In this case, an absorbance of the second i-type semiconductor layer with respect to light of middle wavelength band may increase.

On the other hand, when the Ge content of the second i-type semiconductor layer is 35 atom%, the efficiency of the solar cell has a reduced value of approximately 1.12. In this case, a portion of Ge may operate as a defect inside the second i-type semiconductor layer because of an excessively large amount of Ge. As a result, the efficiency of the solar cell may be reduced in spite of an increase in the Ge content.

Considering the description of FIG. 26, it may be preferable that the Ge content of the second i-type semiconductor layer is approximately 5 to 30 atom%.

As above, in the second and third i-type semiconductor layers doped with Ge as impurities, the Ge content of the third i-type semiconductor layer formed of Ge-doped microcrystalline silicon is less than the Ge content of the second i-type semiconductor layer formed of Ge-doped amorphous silicon. This is because a doping degree of microcrystalline silicon is less than a doping degree of amorphous silicon and a defect generation possibility of Ge of microcrystalline silicon is greater than a defect generation possibility of Ge of amorphous silicon.

In the embodiment, the Ge content indicates a content per unit volume and thus, may be expressed by a concentration.

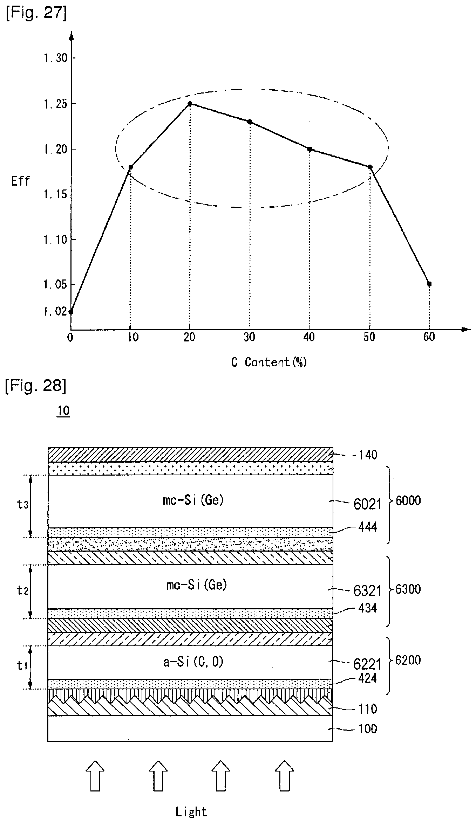

FIG. 27 is a graph illustrating the efficiency of a solar cell depending on a content of impurities contained in a first i-type semiconductor layer. More specifically, FIG. 27 is a graph illustrating the efficiency of a solar cell depending on a content of impurities contained in a first i-type semiconductor layer when a Ge content of a third i-type semiconductor layer is approximately 15 atom% and a Ge content of a second i-type semiconductor layer is approximately 20 atom%. Carbon (C) and oxygen (O) may be used as impurities with which the first i-type semiconductor layer is doped. FIG. 27 illustrates an example where carbon (C) is used as impurities. A result obtained when oxygen (O) is used as impurities may be similar to a result obtained when carbon (C) is used as impurities.

As shown in FIG. 27, when the first i-type semiconductor layer is not doped with carbon, the efficiency of the solar cell is approximately 1.02.

On the other hand, when the carbon content of the first i-type semiconductor layer is 10 to 50 atom%, the efficiency of the solar cell has a sufficiently improved value of approximately 1.18 to 1.25. In this case, an absorbance of the first i-type semiconductor layer with respect to light of a short wavelength band may increase.

On the other hand, when the carbon content of the first i-type semiconductor layer is 60 atom%, the efficiency of the solar cell has a reduced value of approximately 1.05. In this case, a portion of carbon may operate as a defect inside the first i-type semiconductor layer because of the excessive carbon content. As a result, the efficiency of the solar cell may be reduced in spite of an increase in the carbon content.

Considering the description of FIG. 27, it may be preferable that the carbon content of the first i-type semiconductor layer is approximately 10 to 50 atom%.

As shown in FIG. 28, the solar cell 10 according to the embodiment of the invention may include a first photoelectric transformation unit 6200 including a first i-type semiconductor layer 6221 formed of amorphous silicon (a-Si(C, O)) doped with at least one of carbon (C) and oxygen (O) as impurities, a second photoelectric transformation unit 6300 including a second i-type semiconductor layer 6321 formed of Ge-doped microcrystalline silicon (mc-Si(Ge)), a third photoelectric transformation unit 6000 including a third i-type semiconductor layer 6021 formed of Ge-doped microcrystalline silicon (mc-Si(Ge)).

In this case, a thickness t3 of the third i-type semiconductor layer 6021 may be greater than a thickness t2 of the second i-type semiconductor layer 6321, and the thickness t2 of the second i-type semiconductor layer 6321 may be greater than a thickness t1 of the first i-type semiconductor layer 6221.

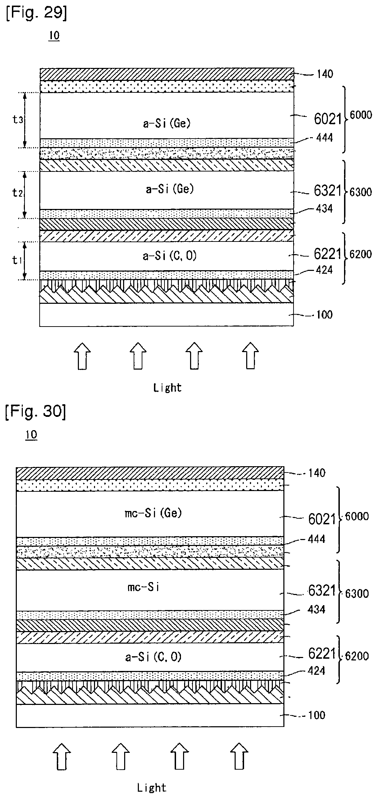

Further, as shown in FIG. 29, the solar cell 10 useful for the understanding of the invention may include a first photoelectric transformation unit 6200 including a first i-type semiconductor layer 6221 formed of amorphous silicon (a-Si(C, O)) doped with at least one of carbon (C) and oxygen (O) as impurities, a second photoelectric transformation unit 6300 including a second i-type semiconductor layer 6321 formed of Ge-doped amorphous silicon (a-Si(Ge)), a third photoelectric transformation unit 6000 including a third i-type semiconductor layer 6021 formed of Ge-doped amorphous silicon (a-Si(Ge)). In other words, all of the first, second, and third i-type semiconductor layers 6221, 6321, and 6021 may contain amorphous silicon.

Further, as shown in FIG. 30, the solar cell 10 according to the embodiment of the invention may include a first photoelectric transformation unit 6200 including a first i-type semiconductor layer 6221 formed of amorphous silicon (a-Si(C, O)) doped with at least one of carbon (C) and oxygen (O) as impurities, a second photoelectric transformation unit 6300 including a second i-type semiconductor layer 6322 formed of microcrystalline silicon (mc-Si), a third photoelectric transformation unit 6000 including a third i-type semiconductor layer 6021 formed of Ge-doped microcrystalline silicon (mc-Si(Ge)). In other words, the third i-type semiconductor layer 6021 formed of microcrystalline silicon may be doped with Ge, and the second i-type semiconductor layer 6322 formed of microcrystalline silicon need not be doped with Ge.

In case the solar cell 10 according to the embodiment of the invention is a single junction solar cell, the i-type semiconductor layer may be doped with impurities.

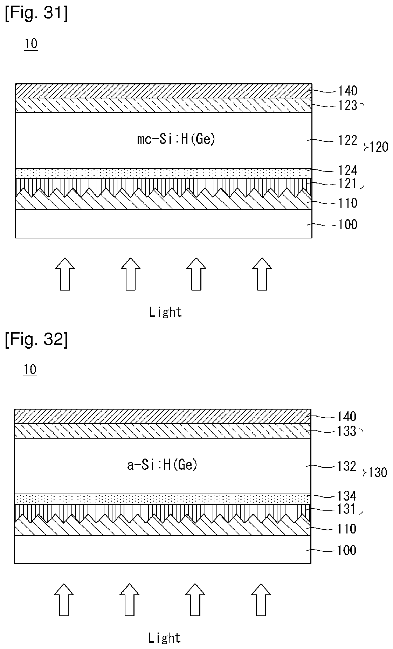

For example, as shown in FIG. 31, when the solar cell 10 being a single junction solar cell includes an i-type semiconductor layer 125 formed of microcrystalline silicon, the i-type semiconductor layer 125 may be doped with Ge.

Alternatively, as shown in FIG. 32, when the solar cell 10 being a single junction solar cell includes an i-type semiconductor layer 135 formed of amorphous silicon, the i-type semiconductor layer 135 may be doped with Ge.

In embodiments of the invention, although most of the same reference numbers refer to the same elements in general, such is not required, and it is understood that the same reference numbers may be used for similar structures in the solar cells.

In embodiments of the invention, reference to front or back, with respect to electrode, a surface of the substrate, or others is not limiting. For example, such a reference is for convenience of description since front or back is easily understood as examples of first or second of the electrode, the surface of the substrate or others.

While this invention has been described in connection with what is presently considered to be practical example embodiments, it is to be understood that the invention is not limited to the disclosed embodiments, but, on the contrary, is intended to cover various modifications included within the scope of the appended claims.

## Claims

1. A solar cell (10), comprising:
a substrate (100);
a first electrode (110) on the substrate;
a second electrode (140); and
at least one photoelectric transformation unit (120, 230, 440, 1300, 6000) positioned between the first electrode and the second electrode, the at least one photoelectric transformation unit including a p-type semiconductor layer (121), an intrinsic, i-type, semiconductor layer (122), an n-type semiconductor layer (123), and a buffer layer (124) positioned between the p-type semiconductor layer and the i-type semiconductor layer, a hydrogen content of the buffer layer being more than a hydrogen content of the i-type semiconductor layer,
wherein the i-type semiconductor layer is formed of microcrystalline silicon,
**characterized in that**:
a crystallinity of the i-type semiconductor layer at a middle position (P2) of the i-type semiconductor layer is larger than a crystallinity of the i-type semiconductor layer in a first junction position (P1) between the buffer layer and the i-type semiconductor layer and smaller than a crystallinity of the i-type semiconductor layer in a second junction position (P3) between the i-type semiconductor layer and the n-type semiconductor layer.

2. The solar cell of claim 1, wherein a thickness (t1) of the buffer layer is less than a thickness (t1) of the i-type semiconductor layer.

3. The solar cell of claim 2, wherein a thickness (t1) of the buffer layer is less than a thickness (t3) of the p-type semiconductor layer.

4. The solar cell of claim 1, wherein the hydrogen content of the buffer layer is more than a hydrogen content of the p-type semiconductor layer.

5. The solar cell of claim 1, wherein the crystallinity of the i-type semiconductor layer in the first junction position (P1) is equal to or greater than 50 % of the crystallinity of the i-type semiconductor layer in the second junction position (P3).

6. The solar cell of claim 5, wherein the crystallinity of the i-type semiconductor layer adjacent to the first junction position (P1) is equal to or greater than 75 % of the crystallinity of the i-type semiconductor layer in the second junction position (P3).

7. The solar cell of claim 1, wherein the i-type semiconductor layer contains germanium, Ge, or contains at least one of carbon, C, and oxygen, O.

8. The solar cell of claim 1, wherein the buffer layer contains germanium, Ge or contains at least one of carbon, C, and oxygen, O.

9. The solar cell of claim 1, wherein at least one photoelectric transformation unit comprises a first photoelectric transformation unit (220) and a second photoelectric transformation unit (230),
the first photoelectric transformation unit being positioned between the first electrode and the second electrode, the first photoelectric transformation unit including a first p-type semiconductor layer (221), a first intrinsic, i-type, semiconductor layer (222) formed of amorphous silicon, a first n-type semiconductor layer (223), and a first buffer layer (224) positioned between the first p-type semiconductor layer and the first i-type semiconductor layer, a hydrogen content of the first buffer layer being more than a hydrogen content of the first i-type semiconductor layer; and
the second photoelectric transformation unit being positioned between the first photoelectric transformation unit and the second electrode, the second photoelectric transformation unit including a second p-type semiconductor layer (231), a second intrinsic, i-type, semiconductor layer (232) formed of microcrystalline silicon, a second n-type semiconductor layer (233), and a second buffer layer (234) positioned between the second p-type semiconductor layer and the second i-type semiconductor layer, a hydrogen content of the second buffer layer being more than a hydrogen content of the second i-type semiconductor layer, wherein the crystallinity of the second i-type semiconductor layer (232) at the middle position (P2) is larger than the crystallinity of the second i-type semiconductor layer (232) in the first junction position (P1) between the second buffer layer (234) and the second i-type semiconductor layer (232) and smaller than the crystallinity of the second i-type semiconductor layer (232) in the second junction position (P3) between the second i-type semiconductor layer (232) and the second n-type semiconductor layer (233).

10. The solar cell of claim 9, wherein a thickness of the first buffer layer is less than a thickness of the first i-type semiconductor layer, and a thickness (t11) of the second buffer layer is less than a thickness (t10) of the second i-type semiconductor layer.

11. The solar cell of claim 9, wherein a crystallinity of the second i-type semiconductor layer in a junction position between the second buffer layer and the second i-type semiconductor layer is equal to or greater than 50 % of a crystallinity of the second i-type semiconductor layer in a junction position between the second i-type semiconductor layer and the second n-type semiconductor layer.

12. The solar cell of claim 11, wherein the crystallinity of the second i-type semiconductor layer in the junction position between the second buffer layer and the second i-type semiconductor layer is equal to or greater than 75 % of the crystallinity of the second i-type semiconductor layer in the junction position between the second i-type semiconductor layer and the second n-type semiconductor layer.

13. The solar cell of claim 9,
wherein a difference between a hydrogen content of the second i-type semiconductor layer and a hydrogen content of the second buffer layer is greater than a difference between a hydrogen content of the first i-type semiconductor layer and a hydrogen content of the first buffer layer.

14. A method of manufacturing the solar cell of claim 1,
wherein the buffer layer forms seeds for crystal growth at the i-type semiconductor layer adjacent to a junction position between the buffer layer and the i-type semiconductor layer.

## Patentansprüche

1. Solarzelle (10), umfassend:
ein Substrat (100);
eine erste Elektrode (110) auf dem Substrat;
eine zweite Elektrode (140); und
zumindest eine fotoelektrische Umwandlungseinheit (120, 230, 440, 1300, 6000), die zwischen der ersten Elektrode und der zweiten Elektrode positioniert ist, wobei die zumindest eine fotoelektrische Umwandlungseinheit eine p-Typ-Halbleiterschicht (121), eine intrinsische, i-Typ, Halbleiterschicht (122), eine n-Typ-Halbleiterschicht (123) und eine Pufferschicht (124) umfasst, die zwischen der p-Typ-Halbleiterschicht und der i-Typ-Halbleiterschicht positioniert ist, wobei ein Wasserstoffgehalt der Pufferschicht mehr als ein Wasserstoffgehalt der i-Typ-Halbleiterschicht beträgt,
wobei die i-Typ-Halbleiterschicht aus mikrokristallinem Silizium ausgebildet ist,
**dadurch gekennzeichnet, dass**:
eine Kristallinität der i-Typ-Halbleiterschicht bei einer mittleren Position (P2) die i-Typ-Halbleiterschicht größer als eine Kristallinität der i-Typ-Halbleiterschicht in einer ersten Kreuzungsposition (P1) zwischen der Pufferschicht und der i-Typ-Halbleiterschicht und kleiner als eine Kristallinität der i-Typ-Halbleiterschicht in einer zweiten Kreuzungsposition (P3) zwischen der i-Typ-Halbleiterschicht und der n-Typ-Halbleiterschicht ist.

2. Solarzelle gemäß Anspruch 1, wobei eine Dicke (t1) der Pufferschicht geringer als eine Dicke (t1) der i-Typ-Halbleiterschicht ist.

3. Solarzelle gemäß Anspruch 2, wobei eine Dicke (t1) der Pufferschicht geringer als eine Dicke (t3) der p-Typ-Halbleiterschicht ist.

4. Solarzelle gemäß Anspruch 1, wobei der Wasserstoffgehalt der Pufferschicht mehr als ein Wasserstoffgehalt der p-Typ-Halbleiterschicht beträgt.

5. Solarzelle gemäß Anspruch 1, wobei die Kristallinität der i-Typ-Halbleiterschicht in der ersten Kreuzungsposition (P1) größer oder gleich 50 % der Kristallinität der i-Typ-Halbleiterschicht in der zweiten Kreuzungsposition (P3) ist.

6. Solarzelle gemäß Anspruch 5, wobei die Kristallinität der i-Typ-Halbleiterschicht angrenzend an die erste Kreuzungsposition (P1) größer oder gleich 75 % der Kristallinität der i-Typ-Halbleiterschicht in der zweiten Kreuzungsposition (P3) ist.

7. Solarzelle gemäß Anspruch 1, wobei die i-Typ-Halbleiterschicht Germanium, Ge, enthält oder zumindest eines aus Kohlenstoff, C, und Sauerstoff, O, enthält.

8. Solarzelle gemäß Anspruch 1, wobei die Pufferschicht Germanium, Ge, enthält oder zumindest eines aus Kohlenstoff, C, und Sauerstoff, O, enthält.

9. Solarzelle gemäß Anspruch 1, wobei die zumindest eine fotoelektrische Umwandlungseinheit eine erste fotoelektrische Umwandlungseinheit (220) und eine zweite fotoelektrische Umwandlungseinheit (230) umfasst,
wobei die erste fotoelektrische Umwandlungseinheit zwischen der ersten Elektrode und der zweiten Elektrode positioniert ist, wobei die erste fotoelektrische Umwandlungseinheit eine erste p-Typ-Halbleiterschicht (221), eine erste intrinsische, i-Typ, Halbleiterschicht (222), die aus amorphem Silizium ausgebildet ist, eine erste n-Typ-Halbleiterschicht (223) und eine erste Pufferschicht (224) umfasst, die zwischen der ersten p-Typ-Halbleiterschicht und der ersten i-Typ-Halbleiterschicht positioniert ist, wobei ein Wasserstoffgehalt der ersten Pufferschicht mehr als ein Wasserstoffgehalt der ersten i-Typ-Halbleiterschicht beträgt; und
die zweite fotoelektrische Umwandlungseinheit zwischen der ersten fotoelektrischen Umwandlungseinheit und der zweiten Elektrode positioniert ist, wobei die zweite fotoelektrische Umwandlungseinheit eine zweite p-Typ-Halbleiterschicht (231), eine zweite intrinsische, i-Typ, Halbleiterschicht (232), die aus mikrokristallinem Silizium ausgebildet ist, eine zweite n-Typ-Halbleiterschicht (233) und eine zweite Pufferschicht (234) umfasst, die zwischen der zweiten p-Typ-Halbleiterschicht und der zweiten i-Typ-Halbleiterschicht positioniert ist, wobei ein Wasserstoffgehalt der zweiten Pufferschicht mehr als ein Wasserstoffgehalt der zweiten i-Typ-Halbleiterschicht beträgt, wobei die Kristallinität der zweiten i-Typ-Halbleiterschicht (232) bei der mittleren Position (P2) größer als die Kristallinität der zweiten i-Typ-Halbleiterschicht (232) in der ersten Kreuzungsposition (P1) zwischen der zweiten Pufferschicht (234) und der zweiten i-Typ-Halbleiterschicht (232) und kleiner als die Kristallinität der zweiten i-Typ-Halbleiterschicht (232) in der zweiten Kreuzungsposition (P3) zwischen der zweiten i-Typ-Halbleiterschicht (232) und der zweiten n-Typ-Halbleiterschicht (233) ist.

10. Solarzelle gemäß Anspruch 9, wobei eine Dicke der ersten Pufferschicht geringer als eine Dicke der ersten i-Typ-Halbleiterschicht ist, und eine Dicke (t11) der zweiten Pufferschicht geringer als eine Dicke (t10) der zweiten i-Typ-Halbleiterschicht ist.

11. Solarzelle gemäß Anspruch 9, wobei eine Kristallinität der zweiten i-Typ-Halbleiterschicht in einer Kreuzungsposition zwischen der zweiten Pufferschicht und der zweiten i-Typ-Halbleiterschicht größer oder gleich 50 % einer Kristallinität der zweiten i-Typ-Halbleiterschicht in einer Kreuzungsposition zwischen der zweiten i-Typ-Halbleiterschicht und der zweiten n-Typ-Halbleiterschicht ist.

12. Solarzelle gemäß Anspruch 11, wobei die Kristallinität der zweiten i-Typ-Halbleiterschicht in der Kreuzungsposition zwischen der zweiten Pufferschicht und der zweiten i-Typ-Halbleiterschicht größer oder gleich 75 % der Kristallinität der zweiten i-Typ-Halbleiterschicht in der Kreuzungsposition zwischen der zweiten i-Typ-Halbleiterschicht und der zweiten n-Typ-Halbleiterschicht ist.

13. Solarzelle gemäß Anspruch 9,
wobei eine Differenz zwischen einem Wasserstoffgehalt der zweiten i-Typ-Halbleiterschicht und einem Wasserstoffgehalt der zweiten Pufferschicht größer als eine Differenz zwischen einem Wasserstoffgehalt der ersten i-Typ-Halbleiterschicht und einem Wasserstoffgehalt der ersten Pufferschicht ist.

14. Verfahren zur Herstellung der Solarzelle gemäß Anspruch 1,
wobei die Pufferschicht Keime für ein Kristallwachstum bei der i-Typ-Halbleiterschicht angrenzend an eine Kreuzungsposition zwischen der Pufferschicht und der i-Typ-Halbleiterschicht ausbildet.

## Revendications

1. Cellule solaire (10) comprenant :
un substrat (100) ;
une première électrode (110) sur le substrat ;
une seconde électrode (140) ; et
au moins une unité de transformation photoélectrique (120, 230, 440, 1300, 6000) positionnée entre la première électrode et la seconde électrode, la au moins une unité de transformation photoélectrique comprenant une couche semi-conductrice de type p (121), une couche semi-conductrice intrinsèque, de type i (122), une couche semi-conductrice de type n (123), et une couche tampon (124) positionnée entre la couche semi-conductrice de type p et la couche semi-conductrice de type i, une teneur en hydrogène de la couche tampon étant supérieure à une teneur en hydrogène de la couche semi-conductrice de type i,
dans laquelle la couche semi-conductrice de type i est formée de silicium microcristallin, **caractérisée en ce que** :
une cristallinité de la couche semi-conductrice de type i au niveau d'une position médiane (P2) de la couche semi-conductrice de type i est supérieure à une cristallinité de la couche semi-conductrice de type i dans une première position de jonction (P1) entre la couche tampon et la couche semi-conductrice de type i et inférieure à une cristallinité de la couche semi-conductrice de type i dans une seconde position de jonction (P3) entre la couche semi-conductrice de type i et la couche semi-conductrice de type n.

2. Cellule solaire selon la revendication 1, dans laquelle une épaisseur (t1) de la couche tampon est inférieure à une épaisseur (t1) de la couche semi-conductrice de type i.

3. Cellule solaire selon la revendication 2, dans laquelle une épaisseur (t1) de la couche tampon est inférieure à une épaisseur (t3) de la couche semi-conductrice de type p.

4. Cellule solaire selon la revendication 1, dans laquelle la teneur en hydrogène de la couche tampon est supérieure à une teneur en hydrogène de la couche semi-conductrice de type p.

5. Cellule solaire selon la revendication 1, dans laquelle la cristallinité de la couche semi-conductrice de type i dans la première position de jonction (P1) est supérieure ou égale à 50 % de la cristallinité de la couche semi-conductrice de type i dans la seconde position de jonction. (P3).

6. Cellule solaire selon la revendication 5, dans laquelle la cristallinité de la couche semi-conductrice de type i adjacente à la première position de jonction (P1) est supérieure ou égale à 75 % de la cristallinité de la couche semi-conductrice de type i dans la seconde position de jonction (P3).

7. Cellule solaire selon la revendication 1, dans laquelle la couche semi-conductrice de type i contient du germanium, Ge, ou contient au moins un atome parmi le carbone, C, et l'oxygène, O.

8. Cellule solaire selon la revendication 1, dans laquelle la couche tampon contient du germanium, Ge ou contient au moins un atome parmi le carbone, C, et l'oxygène, O.

9. Cellule solaire selon la revendication 1, dans laquelle au moins une unité de transformation photoélectrique comprend une première unité de transformation photoélectrique (220) et une seconde unité de transformation photoélectrique (230),
la première unité de transformation photoélectrique étant positionnée entre la première électrode et la seconde électrode, la première unité de transformation photoélectrique comprenant une première couche semi-conductrice de type p (221), une première couche semi-conductrice, intrinsèque, de type i (222) formée de silicium amorphe, une première couche semi-conductrice de type n (223), et une première couche tampon (224) positionnée entre la première couche semi-conductrice de type p et la première couche semi-conductrice de type i, une teneur en hydrogène de la première couche tampon étant supérieure à une teneur en hydrogène de la première couche semi-conductrice de type i ; et
la seconde unité de transformation photoélectrique étant positionnée entre la première unité de transformation photoélectrique et la seconde électrode, la seconde unité de transformation photoélectrique comprenant une seconde couche semi-conductrice de type p (231), une seconde couche semi-conductrice, intrinsèque, de type i (232) formée de silicium microcristallin, une seconde couche semi-conductrice de type n (233), et une seconde couche tampon (234) positionnée entre la seconde couche semi-conductrice de type p et la seconde couche semi-conductrice de type i, une teneur en hydrogène de la seconde couche tampon étant supérieure à une teneur en hydrogène de la seconde couche semi-conductrice de type i, dans laquelle la cristallinité de la seconde couche semi-conductrice de type i (232) au niveau de la position médiane (P2) est supérieure à la cristallinité de la seconde couche semi-conductrice de type i (232) dans la première position de jonction (P1) entre la seconde couche tampon (234) et la seconde couche semi-conductrice de type i (232) et inférieure à la cristallinité de la seconde couche semi-conductrice de type i (232) dans la seconde position de jonction (P3) entre la seconde couche semi-conductrice de type i (232) et la seconde couche semi-conductrice de type n (233).

10. Cellule solaire selon la revendication 9, dans laquelle une épaisseur de la première couche tampon est inférieure à une épaisseur de la première couche semi-conductrice de type i, et une épaisseur (t11) de la seconde couche tampon est inférieure à une épaisseur (t10) de la seconde couche semi-conductrice de type i.

11. Cellule solaire selon la revendication 9, dans laquelle une cristallinité de la seconde couche semi-conductrice de type i dans une position de jonction entre la seconde couche tampon et la seconde couche semi-conductrice de type i est supérieure ou égale à 50 % d'une cristallinité de la seconde couche semi-conductrice de type i dans une position de jonction entre la seconde couche semi-conductrice de type i et la seconde couche semi-conductrice de type n.

12. Cellule solaire selon la revendication 11, dans laquelle la cristallinité de la seconde couche semi-conductrice de type i dans la position de jonction entre la seconde couche tampon et la seconde couche semi-conductrice de type i est supérieure ou égale à 75 % de la cristallinité de la seconde couche semi-conductrice de type i dans la position de jonction entre la seconde couche semi-conductrice de type i et la seconde couche semi-conductrice de type n.

13. Cellule solaire selon la revendication 9,
dans laquelle une différence entre une teneur en hydrogène de la seconde couche semi-conductrice de type i et une teneur en hydrogène de la seconde couche tampon est supérieure à une différence entre une teneur en hydrogène de la première couche semi-conductrice de type i et une teneur en hydrogène de la première couche tampon.

14. Procédé de fabrication de la cellule solaire selon la revendication 1,
dans lequel la couche tampon forme des germes pour la croissance cristalline au niveau de la couche semi-conductrice de type i adjacente à une position de jonction entre la couche tampon et la couche semi-conductrice de type i.
